# DEMANDE DE BREVET EUROPEEN

(11) **EP 4 507 008 A1**
(43) Date de publication de la demande: **12.02.2025**
(21) Numéro de dépôt: 24192998.3
(22) Date de dépôt: 06.08.2024
(51) Int. Cl.: H01L 29/775, H01L 29/778, H01L 29/06, H01L 29/24, H01L 29/423, H01L 21/336, B82Y 10/00, H01L 29/16

(54) **DISPOSITIF MICROÉLECTRONIQUE COMPRENANT UNE GRILLE ENROBANTE ET PROCÉDÉ DE RÉALISATION D'UN TEL DISPOSITIF**

(30) Priorité: 11.08.2023 FR 2308690
(71) Demandeur: Commissariat à l'Energie Atomique et aux Energies Alternatives, 75015 Paris (FR)
(72) Inventeur: BARRAUD, Sylvain, 38054 GRENOBLE Cedex 09 (FR)
(74) Mandataire: Hautier IP

(57) **Abrégé**

L'invention porte sur un dispositif comprenant des transistors (T1, T2, T3) comprenant chacun :
• un canal (41) à base d'un matériau semiconducteur,
• une grille (50) enrobante, entourant totalement ledit canal (41),
• une source (42) et un drain (43) de part et d'autre du canal (41), et des contacts (60S, 60, 60D) de source et drain,
• une couche diélectrique de grille (30) séparant le canal (41) et la grille (50) enrobante,
• des espaceurs (70) de part et d'autre de la grille (50).

Avantageusement, la couche diélectrique de grille (30) et les espaceurs (70) sont formés par au moins une seule et même couche continue (73) entourant la grille (50) enrobante. L'invention porte également sur un procédé de réalisation d'un tel dispositif.

## Description

### DOMAINE TECHNIQUE

L'invention concerne le domaine des technologies de la microélectronique. Elle trouve pour application particulièrement avantageuse la fabrication de dispositifs avancés de type FET (« Field-Effect Transistor » en anglais, ou transistor à effet de champ) à grille enrobante et à canal à base de matériaux semi-conducteurs, tels que des matériaux bidimensionnels (2D) ou d'oxydes semiconducteurs.

### ETAT DE LA TECHNIQUE

L'augmentation constante des performances des transistors a d'abord été permise par la réduction des dimensions des transistors, pour une architecture MOSFET (« Metal-Oxide-Semiconductor Field-Effect Transistor » signifiant transistor à effet de champ Métal-Oxyde-Semiconducteur) classique basée sur le silicium.

Cette architecture classique a ensuite laissé place à d'autres types d'architectures mieux adaptées aux performances spécifiées dans les noeuds technologiques inférieurs à 12 nm. L'architecture dite « finFET » permet par exemple de répondre aux performances fixées par les noeuds technologiques 7 nm et 5nm.

Pour les prochains noeuds technologiques, notamment à partir de 3 nm, d'autres architectures offrant un confinement de grille amélioré sont nécessaires. Une architecture envisagée pour répondre aux problématiques de ces prochains noeuds technologiques comprend des transistors à grille enrobante dits transistors GAA (acronyme de Gate AII Around), comprenant des canaux empilés les uns sur les autres entourés par une grille commune.

Une telle architecture comprend typiquement une pluralité de transistors empilés, chaque transistor comprenant :
- un canal à base d'un matériau semiconducteur,
- une grille dite enrobante, entourant totalement ledit canal,
- une source et un drain de part et d'autre du canal, et des contacts de source et drain connectés respectivement à la source et au drain,
- une couche diélectrique de grille séparant le canal et la grille totalement enrobante,
- des espaceurs de part et d'autre de la grille, configurés pour isoler électriquement la grille vis-à-vis des contacts de source et drain.

Une telle architecture est typiquement obtenue par structuration d'un empilement de deux types de couches alternées, où l'un des types de couches comprend des couches semiconductrices destinées à former les canaux des transistors, et l'autre des types de couches comprend des couches sacrificielles destinées à être remplacées par la grille enrobante.

Pour réduire les dimensions des transistors et améliorer la compacité et l'intégration tout en limitant les capacités parasites dans cette architecture de dispositif, une solution consiste à former des espaceurs « internes ». Ces espaceurs internes sont formés dans les couches sacrificielles, entre les couches semiconductrices, comme illustré par exemple dans le document « N. Loubet et al., 2017 Symposium on VLSI Technology Digest of Technical Papers ». Une difficulté liée à la fabrication de ces architectures concerne le contrôle dimensionnel des espaceurs internes. Le retrait partiel des couches sacrificielles pour former les espaceurs internes reste mal maîtrisé. Une variabilité des dimensions des espaceurs internes dans l'empilement des couches est observée. Il est en outre difficile d'aligner ces espaceurs internes vis-à-vis des motifs de grille définis lors de la structuration de l'empilement.

Une fabrication industrielle maîtrisée, satisfaisant aux exigences de qualité requises, est un enjeu important pour le développement des technologies de transistors GAA.

Il existe donc un besoin pour un procédé de fabrication de transistors GAA présentant une reproductibilité améliorée et un coût de fabrication limité.

Un objectif de l'invention est de proposer un tel procédé de fabrication reproductible, maîtrisé et limitant le coût de fabrication. Un autre objectif de l'invention est de proposer un dispositif présentant une architecture pouvant être reproduite plus facilement et avec plus de maîtrise. Un autre objectif de l'invention est de pallier au moins en partie les inconvénients des procédés et dispositifs connus.

### RESUME

Pour atteindre ces objectifs, selon un mode de réalisation on prévoit un dispositif microélectronique comprenant au moins un transistor comprenant:
- au moins deux canaux empilés selon une direction principale z, chaque canal étant à base d'un matériau semiconducteur,
- une grille dite enrobante, entourant totalement au moins un desdits canaux, et de préférence plusieurs canaux,
- une source et un drain de part et d'autre de chaque canal, et des contacts de source et de drain connectés respectivement à la source et au drain,
- une couche diélectrique de grille séparant chaque canal et la grille enrobante,
- des espaceurs de part et d'autre de la grille, configurés pour isoler électriquement la grille vis-à-vis des contacts de source et de drain,

Avantageusement, la couche diélectrique de grille et les espaceurs sont formés au moins par une même couche continue entourant la grille enrobante.

Une telle architecture de dispositif ne nécessite pas de mettre en oeuvre un retrait partiel de couches sacrificielles pour former les espaceurs, contrairement aux architectures connues basées sur des espaceurs « internes ».

Dans cette architecture, une seule et même couche continue forme à la fois les espaceurs et la couche diélectrique de grille. Typiquement, les portions verticales de cette couche continue correspondent aux espaceurs et les portions horizontales de cette couche continue correspondent à la couche diélectrique de grille. L'épaisseur de la couche continue peut être avantageusement précisément contrôlée. II est significativement plus simple d'obtenir un contrôle précis sur l'épaisseur d'une couche, en l'espèce la couche continue, que d'obtenir un contrôle précis sur un retrait partiel de couche, comme envisagé dans l'art antérieur. Le contrôle dimensionnel des espaceurs du dispositif est donc significativement amélioré. Les espaceurs sont en outre avantageusement auto-alignés vis-à-vis de la grille totalement enrobante.

Un autre aspect de l'invention concerne un procédé de fabrication d'un dispositif microélectronique, comprenant les étapes suivantes :
- Fournir sur un substrat un empilement selon la direction principale z comprenant une première pluralité de premières couches en un premier matériau alternées avec une deuxième pluralité de deuxièmes couches en un deuxième matériau, les premier et deuxième matériaux étant différents dudit matériau semiconducteur,
- Former dans cet empilement des premières ouvertures définissant des premiers motifs,
- Former des grilles sacrificielles à cheval sur les premiers motifs et en partie dans les premières ouvertures,
- Former dans les premiers motifs des deuxièmes ouvertures définissant des deuxièmes motifs,
- Retirer totalement, à partir des deuxièmes ouvertures, le premier matériau des premières couches de sorte à former des premiers espaces,
- Retirer les grilles sacrificielles de sorte à former des troisièmes ouvertures,
- Retirer totalement, à partir des troisièmes ouvertures, le deuxième matériau des deuxièmes couches, de sorte à former des deuxièmes espaces,
- Déposer une couche continue, à base d'un matériau diélectrique, autour des deuxièmes couches ou dans les deuxièmes espaces, de façon à former :
   ∘ Une couche diélectrique de grille à partir des parties horizontales de la couche continue,
   ∘ Des espaceurs à partir des parties verticales de la couche continue,
- Après formation de la couche continue, déposer une couche à base d'un matériau semiconducteur dans les premiers espaces, de sorte à former :
   ∘ des canaux à base du matériau semiconducteur, et
   ∘ des sources et drains à base du matériau semiconducteur de part et d'autre des canaux,
- Après formation de la couche continue, remplir par un matériau, dit matériau de grille, les deuxièmes espaces, de façon à former des grilles dites enrobantes entourant totalement au moins un des canaux de l'au moins un transistor.

Un principe du procédé selon l'invention consiste à former une couche continue comprenant à la fois les espaceurs et la couche diélectrique de grille. Cette couche continue peut être formée autour des deuxièmes couches, lorsque le procédé est typiquement de type « gate last » (le remplacement des grilles sacrificielles par des grilles fonctionnelles se fait après la formation des canaux des transistors). Alternativement, la couche continue peut être formée dans les deuxièmes espaces, lorsque le procédé est typiquement de type « gate first » (le remplacement des grilles sacrificielles par des grilles fonctionnelles se fait avant la formation des canaux des transistors). Les avantages mentionnés ci-dessus dans le cadre du dispositif pour la couche continue s'appliquent *mutatis mutandis* au procédé. La couche continue peut notamment être déposée en contrôlant précisément son épaisseur, au niveau des parties verticales et au niveau des parties horizontales. La couche continue peut par exemple être déposée de façon conforme.

Un autre principe du procédé selon l'invention consiste à remplacer sélectivement certaines couches de l'empilement initial par un matériau semiconducteur afin de former les canaux de transistors. L'empilement initial ne comprend pas le matériau semiconducteur. Le dépôt ultérieur du matériau semiconducteur vise à mieux préserver le matériau semiconducteur. Selon une possibilité préférée, le matériau semiconducteur est un matériau bidimensionnel (2D) choisi parmi les dichalcogénures de métaux de transition MX2 avec M pris parmi le molybdène (Mo) ou le tungstène (W), et X pris parmi le soufre (S) ou le sélénium (Se).

Ainsi, le procédé selon l'invention permet d'introduire des couches de matériau 2D après structuration de l'empilement. Cela permet avantageusement de limiter le risque de dégradation du matériau 2D au cours du procédé. Le matériau 2D n'est pas exposé à toutes les étapes du procédé de fabrication. Le matériau 2D est ainsi préservé.

En outre, l'introduction tardive du matériau 2D au cours du procédé de fabrication permet d'utiliser les technologies standard de la microélectronique pour la formation et la structuration de l'empilement. Il n'est pas nécessaire de modifier ou d'adapter les étapes technologiques standard de structuration aux contraintes d'utilisation du matériau 2D. Les coûts du procédé sont ainsi avantageusement limités. Le procédé peut en outre être plus facilement implémenté dans des lignes de production existantes.

Les autres objets, caractéristiques et avantages de la présente invention apparaîtront à l'examen de la description suivante et des dessins d'accompagnement. Il est entendu que d'autres avantages peuvent être incorporés.

### BREVE DESCRIPTION DES FIGURES

Les figures nA (n=1 ... 12) illustrent schématiquement selon des coupes transverses xz des étapes de fabrication d'un dispositif à transistors superposés, selon un premier mode de réalisation de la présente invention.
Les figures nB (n=1 ... 12) illustrent schématiquement selon des coupes transverses yz indiquées sur les figures nA correspondantes, les mêmes étapes de fabrication du dispositif, selon un premier mode de réalisation de la présente invention.
Les figures nA (n=13...20) illustrent schématiquement selon des coupes transverses xz des étapes de fabrication d'un dispositif à transistors superposés, selon un deuxième mode de réalisation de la présente invention.
Les figures nB (n=13...20) illustrent schématiquement selon des coupes transverses yz indiquées sur les figures nA correspondantes, les mêmes étapes de fabrication du dispositif, selon un deuxième mode de réalisation de la présente invention.
Les figures nA (n=21...31) illustrent schématiquement selon des coupes transverses xz des étapes de fabrication d'un dispositif à transistors superposés, selon un troisième mode de réalisation de la présente invention.
Les figures nB (n=21...31) illustrent schématiquement selon des coupes transverses yz indiquées sur les figures nA correspondantes, les mêmes étapes de fabrication du dispositif, selon un troisième mode de réalisation de la présente invention.

Les premier et deuxième modes de réalisation prévoient le remplacement des grilles sacrificielles après formation des canaux des transistors. Ils correspondent typiquement à des modes de réalisation dits « gate last » (la grille est formée en dernier). Le troisième mode de réalisation prévoit le remplacement des grilles sacrificielles avant formation des canaux des transistors. Il correspond typiquement à un mode de réalisation dit « gate first » (la grille est formée en premier).

Sur les figures en coupes transverses, des plans de coupe sont indiqués (A-A', B-B', ..., P-P', ..., Z-Z', α- α', ..., ε-ε') avec des références croisées aux plans de coupe des figures correspondantes. Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs et/ou les dimensions des différentes couches, motifs et reliefs ne sont pas représentatives de la réalité. Pour des raisons de clarté, l'ensemble des références alphanumériques n'est pas systématiquement repris d'une figure à l'autre. Il est entendu que les éléments déjà décrits et référencés, lorsqu'ils sont reproduits sur une autre figure, portent typiquement les mêmes références alphanumériques, même si celles-ci ne sont pas explicitement mentionnées. L'homme du métier identifiera sans difficultés un même élément reproduit sur différentes figures.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, l'empilement comprend une alternance d'une première couche de la première pluralité avec une deuxième couche de la deuxième pluralité. De préférence, ladite première couche et ladite deuxième couche sont en contact. Selon un exemple, le dispositif final comprend des canaux de transistors formés après retrait sélectif des premières couches de l'empilement initial. Selon un exemple, le dispositif final comprend des grilles enrobantes formées après retrait sélectif des deuxièmes couches de l'empilement initial. L'empilement initial ne comprend typiquement ni le matériau semiconducteur des canaux de transistors, ni le matériau des grilles enrobantes.
Selon un exemple, la couche continue présente des parties dites horizontales, s'étendant dans un plan perpendiculaire à la direction principale z et des parties dites verticales, s'étendant dans des plans parallèles à la direction principale z, et la couche diélectrique de grille correspond aux parties horizontales de la couche continue, et les espaceurs correspondent aux parties verticales de la couche continue.
Selon un exemple, les parties verticales de la couche continue, destinées à former les espaceurs, présentent une épaisseur différente de celle des parties horizontales de la couche continue, destinées à former la couche diélectrique de grille.
Selon un autre exemple, le dépôt de la couche continue est conforme et les parties verticales et horizontales présentent sensiblement la même épaisseur.
Selon un exemple, la couche continue présente une épaisseur sensiblement constante.
Selon un exemple, la couche continue comprend une pluralité de couches continues superposées les unes aux autres.
Selon un exemple, les espaceurs formés à partir de la couche continue sont directement au contact de la couche à base du matériau semiconducteur, sans espaceur additionnel intercalé entre ladite couche et la couche continue.
Selon un exemple, la grille totalement enrobante est commune à tous les canaux de l'au moins un transistor, ladite grille présentant une partie supérieure flanquée par des espaceurs additionnels sans continuité avec la couche diélectrique de grille. Ces espaceurs additionnels sont typiquement directement au contact des flancs de la grille enrobante. Ces espaceurs additionnels permettent de réduire les capacités parasites dans le dispositif.
Selon un exemple, la source et le drain sont communs à tous les canaux de l'au moins un transistor.
Selon un exemple, le dépôt de la couche à base du matériau semiconducteur est configuré pour former des portions verticales de couche à base du matériau semiconducteur sur les flancs du deuxième motif et des portions horizontales de couche à base du matériau semiconducteur dans les premiers espaces. Cela permet de faciliter la reprise des contacts de source et drain dans le dispositif.
Selon un exemple, les portions verticales de la couche à base du matériau semiconducteur sont plus épaisses que les portions horizontales. Des portions verticales plus épaisses permettent de diminuer la résistance de contact des contacts source et drain.
Selon un exemple, le procédé comprend une formation de contacts de source et de drain dans les deuxièmes ouvertures, après dépôt de la couche à base du matériau semiconducteur.
Selon un exemple, la formation des grilles enrobantes est effectuée après le dépôt de la couche à base du matériau semiconducteur. Ce type de procédé appelé « gate last », où la grille fonctionnelle est formée en fin de procédé en remplacement d'une grille sacrificielle, permet de préserver les caractéristiques dimensionnelles de la grille fonctionnelle. Le budget thermique lié au dépôt du matériau semiconducteur n'impacte pas l'épaisseur équivalente d'oxyde de grille à l'interface avec la grille. Les caractéristiques structurelles et électriques de la grille fonctionnelle sont mieux contrôlées.
Selon un exemple, le retrait des grilles sacrificielles et le retrait du deuxième matériau des deuxièmes couches sont effectués après dépôt de la couche à base du matériau semiconducteur. Selon un exemple, le dépôt de l'au moins une couche continue se fait autour des deuxièmes couches.
Selon un exemple, le retrait du premier matériau des premières couches est effectué sélectivement au deuxième matériau des deuxièmes couches.
Selon un exemple, le procédé comprend en outre, avant formation des deuxièmes ouvertures, une formation d'espaceurs additionnels sur les premiers motifs et bordant les grilles sacrificielles.
Selon un exemple, le procédé est un procédé de type « gate last » et comprend les étapes ci-dessous enchaînées dans l'ordre suivant :
   - Fournir sur un substrat l'empilement selon la direction principale z comprenant la première pluralité de premières couches en un premier matériau alternées avec la deuxième pluralité de deuxièmes couches en un deuxième matériau, les premier et deuxième matériaux étant différents du matériau semiconducteur,
   - Former dans cet empilement les premières ouvertures définissant les premiers motifs,
   - Former les grilles sacrificielles à cheval sur les premiers motifs et en partie dans les premières ouvertures,
   - Former dans les premiers motifs les deuxièmes ouvertures définissant les deuxièmes motifs,
   - Retirer totalement, à partir des deuxièmes ouvertures, le premier matériau des premières couches de sorte à former les premiers espaces,
   - Déposer la couche continue, à base d'un matériau diélectrique, autour des deuxièmes couches, de façon à former :
      ∘ la couche diélectrique de grille à partir des parties horizontales de la couche continue,
      ∘ les espaceurs à partir des parties verticales de la couche continue,
   - Déposer la couche à base d'un matériau semiconducteur sur la couche continue, dans les premiers espaces, de sorte à former :
      ∘ les canaux à base du matériau semiconducteur, et
      ∘ les sources et drains à base du matériau semiconducteur de part et d'autre des canaux,
   - Retirer les grilles sacrificielles de sorte à former les troisièmes ouvertures,
   - Retirer totalement, à partir des troisièmes ouvertures, le deuxième matériau des deuxièmes couches, de sorte à former les deuxièmes espaces,
   - Remplir par le matériau de grille les deuxièmes espaces, de façon à former les grilles enrobantes entourant totalement au moins un canal de l'au moins un transistor.
Selon un exemple, le retrait des grilles sacrificielles et le retrait du deuxième matériau des deuxièmes couches sont effectués avant dépôt de la couche à base du matériau semiconducteur. Selon un exemple, le dépôt de l'au moins une couche continue se fait dans les deuxièmes espaces.
Selon un exemple, le procédé comprend en outre, après formation des deuxièmes ouvertures, un dépôt d'au moins une couche de maintien dans lesdites deuxièmes ouvertures, sur des flancs exposés des premières et deuxièmes couches.
Selon un exemple, le procédé comprend en outre, après remplissage des deuxièmes espaces par le matériau de grille, un retrait de l'au moins une couche de maintien de façon à exposer les flancs des premières couches.
Selon un exemple, le procédé est un procédé de type « gate first » et comprend les étapes ci-dessous enchaînées dans l'ordre suivant :
   - Fournir sur un substrat l'empilement selon la direction principale z comprenant la première pluralité de premières couches en un premier matériau alternées avec la deuxième pluralité de deuxièmes couches en un deuxième matériau, les premier et deuxième matériaux étant différents du matériau semiconducteur,
   - Former dans cet empilement les premières ouvertures définissant les premiers motifs,
   - Former les grilles sacrificielles à cheval sur les premiers motifs et en partie dans les premières ouvertures,
   - Former dans les premiers motifs les deuxièmes ouvertures définissant les deuxièmes motifs,
   - Former la couche de maintien dans lesdites deuxièmes ouvertures, sur des flancs exposés des premières et deuxièmes couches,
   - Retirer les grilles sacrificielles de sorte à former les troisièmes ouvertures,
   - Retirer totalement, à partir des troisièmes ouvertures, le deuxième matériau des deuxièmes couches, de sorte à former les deuxièmes espaces,
   - Déposer la couche continue, à base d'un matériau diélectrique, dans les deuxièmes espaces, de façon à former :
      ∘ la couche diélectrique de grille à partir des parties horizontales de la couche continue,
      ∘ les espaceurs à partir des parties verticales de la couche continue,
   - Remplir par le matériau de grille les deuxièmes espaces, de façon à former les grilles enrobantes,
   - Retirer la couche de maintien de façon à exposer les flancs des premières couches,
   - Retirer totalement, à partir des deuxièmes ouvertures, le premier matériau des premières couches de sorte à former les premiers espaces,
   - Déposer la couche à base d'un matériau semiconducteur sur la couche continue, dans les premiers espaces, de sorte à former :
      ∘ les canaux à base du matériau semiconducteur, et
      ∘ les sources et drains à base du matériau semiconducteur de part et d'autre des canaux.
Selon un exemple, le dépôt de la couche continue est effectué par dépôt chimique en phase vapeur ou par dépôt en couche atomique. Les dépôts chimiques en phase vapeur sont faciles à mettre en oeuvre. Les dépôts en couche atomiques permettent de contrôler précisément l'épaisseur de la couche continue à base du matériau diélectrique.
Selon un exemple, le dépôt de la couche à base du matériau semiconducteur est effectué par dépôt chimique en phase vapeur ou par dépôt en couche atomique. Les dépôts chimiques en phase vapeur sont faciles à mettre en oeuvre. Les dépôts en couche atomiques permettent de contrôler précisément l'épaisseur de la couche à base du matériau semiconducteur.
Selon un exemple, le matériau semiconducteur est choisi parmi les dichalcogénures de métaux de transition MX2 avec M pris parmi le molybdène (Mo) ou le tungstène (W), et X pris parmi le soufre (S), le sélénium (Se) ou le tellure (Te).
Selon un autre exemple, le matériau semiconducteur est choisi à base d'un oxyde semiconducteur, par exemple à base d'IGZO (Oxyde de zinc-indium-gallium), d'ln2O3, d'IWO (oxyde d'indium dopé au tungstène), d'ITO (Oxyde d'étain-indium), d'IAZO (Oxyde de zinc-indium-aluminium), d'InGaZnO, d'InGaO, d'InZnO ou d'un oxyde semiconducteur amorphe.
Selon un exemple, le premier matériau est choisi en SiGe et le deuxième matériau est choisi en Si, ou inversement. Ces matériaux peuvent être facilement épitaxiés par des procédés technologiques classiques de la microélectronique. Cela permet de bénéficier des voies technologiques existantes. Le coût du procédé est réduit.
Selon un exemple, la formation des grilles sacrificielles est effectuée de manière à ce que les grilles sacrificielles s'étendent sur toute une hauteur des premières ouvertures. Selon un exemple, les premières ouvertures s'étendent selon toute la hauteur de l'empilement des premières et deuxièmes couches. Les grilles sacrificielles s'étendent sur toute la hauteur de l'empilement. Les grilles sacrificielles prennent typiquement appui sur le substrat. Cela permet de donner un accès à toutes les couches de l'empilement via les troisièmes ouvertures, lors du retrait des grilles sacrificielles.
Selon un exemple, le dépôt de la couche à base du matériau semiconducteur est configuré pour que la couche à base du matériau semiconducteur remplisse totalement les premiers espaces.
Selon un autre exemple, le dépôt de la couche à base du matériau semiconducteur est configuré pour que la couche à base du matériau semiconducteur remplisse partiellement les premiers espaces. Selon un exemple, le procédé comprend en outre, après dépôt de la couche à base du matériau semiconducteur, un dépôt d'une couche diélectrique configuré pour combler les premiers espaces. Cela permet de former une couche à base du matériau semiconducteur de faible épaisseur, sans contrainte sur l'épaisseur des premières couches de l'empilement initial. La couche à base du matériau semiconducteur peut présenter une épaisseur inférieure à celle des premières couches de l'empilement initial.
Selon un exemple, le substrat est un substrat massif à base de silicium.
Selon un exemple, l'empilement comprend au moins trois premières couches du premier matériau alternées avec trois deuxièmes couches du deuxième matériau.
Selon un exemple, l'empilement comprend autant de premières couches du premier matériau que de deuxièmes couches du deuxième matériau.
Selon un exemple, le retrait du premier matériau des premières couches sélectivement au deuxième matériau des deuxièmes couches est effectué par une première gravure sélective présentant une sélectivité S_{10:20} d'au moins 5:1, de préférence au moins 10:1. Cette première gravure sélective est typiquement arrêtée au temps.
Selon un exemple, le retrait du deuxième matériau des deuxièmes couches sélectivement au premier matériau des premières couches est effectué par une deuxième gravure sélective présentant une sélectivité S_{20:10} d'au moins 5:1, de préférence au moins 10:1.

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention. Les caractéristiques et les avantages d'un aspect de l'invention, par exemple le dispositif ou le procédé, peuvent être adaptés *mutatis mutandis* à l'autre aspect de l'invention.

L'invention porte d'une manière générale sur un dispositif microélectronique à transistors GAA et un procédé de fabrication de ce dispositif. Un tel dispositif microélectronique peut présenter une architecture de type « GAA stacked nanosheet », c'est-à-dire à nanofeuilles empilées et grille totalement enrobante. Une architecture à nanofils empilés et grille totalement enrobante est également possible.

Les nanofils ou nanofeuilles comprennent typiquement chacun un canal de conduction d'un transistor. Ces canaux sont empilés selon une direction z. Cela signifie qu'ils occupent chacun un niveau d'altitude donnée selon la direction z. Un niveau peut être défini entre deux plans perpendiculaires à la direction z.

De manière avantageuse, le procédé selon l'invention peut être mis en oeuvre pour la réalisation de transistors MOS GAA pour les noeuds technologiques 5 nm et sub-5 nm.

Un dispositif microélectronique comprenant des transistors GAA superposés peut être avantageusement intégré dans des systèmes logiques présentant des architectures 3D. Ces transistors peuvent notamment être associés à d'autres éléments structuraux ou fonctionnels de façon à concevoir des systèmes complexes.

Un aspect particulier de l'invention concerne la mise en oeuvre de matériaux 2D pour réaliser les nanofils ou nanofeuilles du dispositif.

Les matériaux 2D correspondent typiquement à des composés présentant une structure lamellaire constituée de feuillets bidimensionnels, empilés selon l'axe cristallographique c. Les liaisons atomiques au sein de chaque feuillet sont fortes, de nature covalente. Les liaisons entre feuillets sont beaucoup plus faibles, de type Van der Waals. Ces feuillets bidimensionnels sont également appelés monocouches.

Dans le cadre de la présente invention, les monocouches sont de préférence des monocouches semiconductrices du type MX2 où M est du molybdène (Mo) ou du tungstène (W) et X du soufre (S) ou du sélénium (Se). Chaque « monocouche » est ici composée d'un plan de cations métalliques M inséré entre deux plans d'anions X. Une monocouche comprend donc ici typiquement trois plans atomiques : les atomes du métal de transition (Mo ou W) forment un plan pris en sandwich entre deux plans de chalcogènes (S, Se ou Te, par exemple). Chaque atome de métal de transition est relié à six atomes de chalcogène. Ces anions sont en coordination trigonale prismatique par rapport aux atomes de métal. Les monocouches de dichalcogénures de métaux de transition MX2 présentent un réseau atomique hexagonal.

Les monocouches de dichalcogénures de métaux de transition MX2 sont de préférence à base de disulfure de molybdène MoS2, MoSe2, MoTe2, WS2, WSe2.

Une possibilité alternative concerne la mise en oeuvre d'oxydes semiconducteurs pour réaliser les nanofils ou nanofeuilles du dispositif. Ces oxydes semiconducteurs sont de préférence à base d'IGZO (Oxyde de zinc indium-gallium), d'ln2O3, d'IWO (oxyde d'indium dopé au tungstène), d'InGaZnO, d'InGaO, d'InZnO, d'IAZO ou d'ITO (Oxyde d'étain-indium). Une autre possibilité concerne la mise en oeuvre de graphène, de nitrure de bore hexagonal « h-BN », de phosphorène (également connu sous le nom de « Black Phosphorous » BP), notamment sous forme de monocouche.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt ou l'application d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

On entend par un substrat, un film, une couche, « à base » d'un matériau A, un substrat, un film, une couche comprenant ce matériau A uniquement ou ce matériau A et éventuellement d'autres matériaux, par exemple des éléments dopants ou des éléments d'alliage. Ainsi, un espaceur à base de nitrure de silicium SiN peut par exemple comprendre du nitrure de silicium non stoechiométrique (SiN), ou du nitrure de silicium stoechiométrique (Si3N4), ou encore un oxy-nitrure de silicium (SiON).

On entend par une couche « continue », une couche présentant une continuité de matière. Typiquement, la couche continue enrobe les deuxièmes couches des deuxièmes motifs, ou tapisse les deuxièmes espaces des deuxièmes motifs.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 20. Dans la présente invention, la couche diélectrique peut présenter des propriétés ferroélectriques.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

On entend par « gravure sélective vis-à-vis de » ou « gravure présentant une sélectivité vis-à-vis de » une gravure configurée pour enlever un matériau A ou une couche A vis-à-vis d'un matériau B ou d'une couche B, et présentant une vitesse de gravure du matériau A supérieure à la vitesse de gravure du matériau B. La sélectivité est le rapport entre la vitesse de gravure du matériau A sur la vitesse de gravure du matériau B. Elle est notée S_{A:B}. Une sélectivité S_{A:B} de 10:1 signifie que la vitesse de gravure du matériau A est 10 fois supérieure à la vitesse de gravure du matériau B.

Les différents motifs formés au cours des étapes de fabrication présentent typiquement une structure destinée à évoluer lors des étapes du procédé. Ainsi, les motifs peuvent comprendre les couches sacrificielles de l'empilement initial, les couches à base de matériau 2D ou d'oxyde semiconducteur, les couches diélectriques, continues ou discontinues. Les différents motifs visent à former, en fin de procédé, des « motifs de transistors » comprenant chacun au moins un canal de conduction et une grille entourant ledit canal, une barrière diélectrique séparant la grille et le canal, une source et un drain de part et d'autre du canal. L'assignation des premières et deuxièmes couches dans l'empilement initial peut être inversée.

Un repère de préférence orthonormé, comprenant les axes x, y, z est représenté sur les figures annexées.

Dans la présente demande de brevet, on parlera préférentiellement d'épaisseur pour une couche ou un film, et de hauteur pour un dispositif ou une structure. L'épaisseur est prise selon une direction normale au plan d'extension principal de la couche ou du film. Ainsi, une couche superficielle de silicium (topSi) présente typiquement une épaisseur selon z. Un motif de grille formé sur une telle couche superficielle présente une hauteur selon z. Les termes relatifs « sur », « surmonte », « sous », « sous-jacent » se réfèrent à des positions prises selon la direction z. Les termes « vertical », « verticalement » se réfèrent à des orientations selon la direction z. Une portion verticale s'étend typiquement selon un plan comprenant la direction z. Les termes « horizontal », « horizontalement » se réfèrent à des orientations perpendiculaires à la direction z. Une portion horizontale s'étend typiquement selon un plan xy perpendiculaire à la direction z. Une dimension « latérale » correspond à une dimension selon une direction du plan xy. On entend par une extension « latérale » ou « latéralement », une extension selon une ou des directions du plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures en coupe transverse.

Les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

La description qui suit présente des exemples de mise en oeuvre du procédé selon l'invention dans un contexte d'élaboration d'un dispositif 3D complexe. Le cadre de cette description n'est évidemment pas limitatif de l'invention.

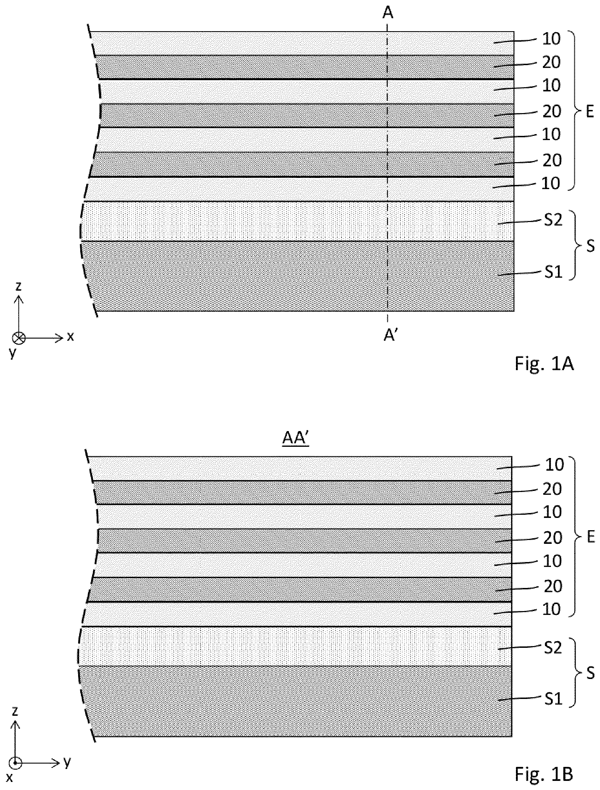

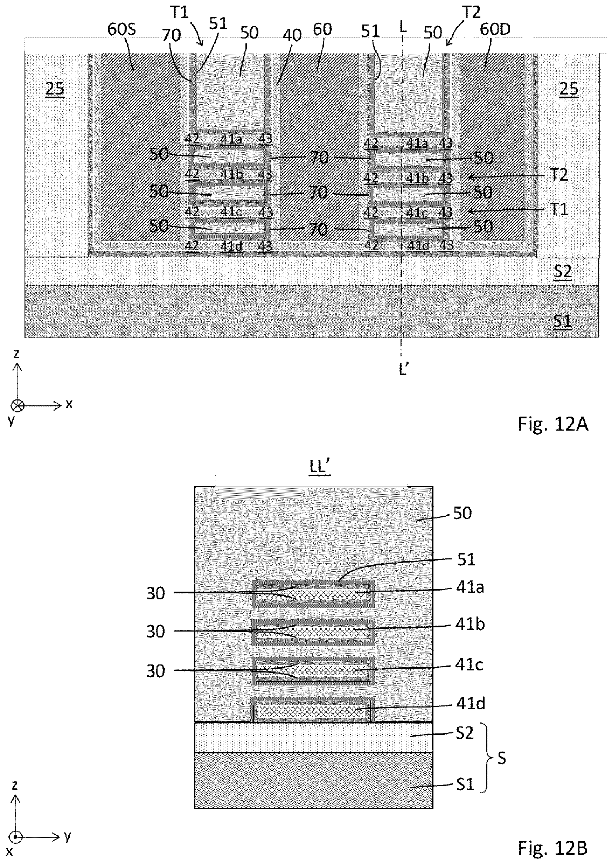

Les figures 1A, 1B à 12A, 12B illustrent schématiquement des étapes de fabrication d'un dispositif comprenant des transistors GAA selon un premier mode de réalisation. Les figures nA (n=1...12) correspondent à des premières coupes transverses illustrant chacune une étape différente du procédé de fabrication. Les figures nB (n=1...12) correspondent à des deuxièmes coupes transverses illustrant chacune la même étape que la figure nA correspondante.

Comme illustré aux figures 1A, 1B, une première étape consiste à réaliser un empilement E de couches semi-conductrices 10, 20 sur un substrat S. Le substrat S peut être un substrat de type SOI (Silicium sur isolant), GeOl (Germanium sur isolant) ou SGOI (Silicium-Germanium sur isolant). Ces substrats connus comprennent, selon la terminologie courante pour l'homme du métier, une couche S1 de silicium épaisse dite « Si bulk », une couche S2 d'oxyde de silicium dite « BOX » (Burried Oxide) et une couche mince superficielle, respectivement à base de silicium, de germanium ou de silicium-germanium. Cette couche mince superficielle peut avantageusement correspondre à la première couche 10 de l'empilement E.

Alternativement, le substrat S peut être un substrat massif « Si bulk ».

L'empilement E comprend selon un exemple une alternance de premières couches 10 en silicium-germanium (SiGe) et de deuxièmes couches 20 en silicium (Si).

La concentration du Ge dans l'alliage SiGe peut être de 20%, 30% ou 45% par exemple. Cette concentration de germanium est choisie de façon à permettre une bonne sélectivité de la gravure du SiGe par rapport au Si, lors des étapes de gravure sélective. Plus la concentration de Ge sera importante, plus la sélectivité au Si sera grande lors du retrait ultérieur du SiGe. Cet empilement E est avantageusement formé par épitaxie des couches de SiGe 10 et de Si 20. Cette étape de formation de l'empilement E est peu coûteuse et bien connue de l'homme du métier. Les épaisseurs des couches Si et SiGe peuvent être typiquement de l'ordre de 10 nm, et plus généralement comprises entre 5 nm et 20 nm par exemple. De façon connue afin d'éviter la formation de défauts structuraux, les épaisseurs maximales permises pour les couches 10 en SiGe dépendent notamment de la concentration en Ge choisie.

Dans l'exemple illustré aux figures 1A, 1B quatre couches 10 de SiGe sont alternées avec trois couches 20 de Si épitaxiées. Un super réseau Si/SiGe est ainsi obtenu. Le nombre de couches de Si et de SiGe peut naturellement être augmenté. Cela permet *in fine* d'augmenter le nombre de transistors empilés dans le dispositif final.

D'une façon générale le premier matériau des premières couches 10 et le deuxième matériau des deuxièmes couches 20 sont choisis de façon à ce que l'un puisse être gravé sélectivement par rapport à l'autre. Ainsi, d'autres couples de premier et deuxième matériaux sont possibles. En respectant cette condition de sélectivité à la gravure, les premier et deuxième matériaux peuvent être choisis parmi les matériaux diélectriques (oxydes et nitrures par exemple), les matériaux semiconducteurs, les matériaux métalliques.

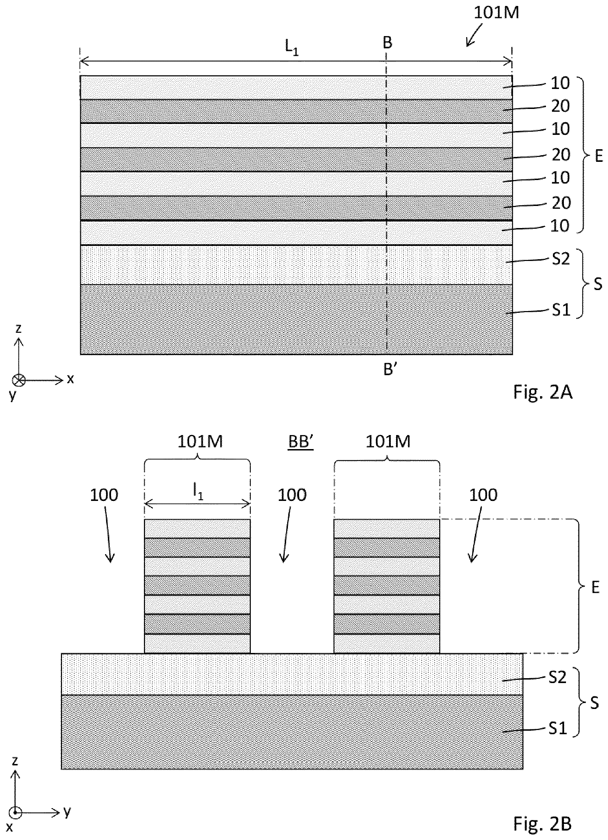

Comme illustré aux figures 2A, 2B, une étape classique de lithographie/gravure est réalisée afin de définir des premiers motifs 101M, et des premières ouvertures 100. La gravure est anisotrope et dirigée selon z. Elle est configurée pour graver l'empilement E, ici le super réseau Si/SiGe, sur toute sa hauteur, en s'arrêtant sur le substrat S, ici le BOX S2. Elle peut être effectuée par plasma en utilisant une chimie de gravure HBr/O2. Les premiers motifs 101M peuvent présenter une longueur L₁ selon x comprise entre 10 nm et 500 nm. Ils présentent de préférence une largeur l₁ selon y comprise entre 10 nm et 120 nm, par exemple de l'ordre de 40 nm. Cette première structuration de l'empilement E sous forme d'ailettes ou « fins » selon la terminologie anglo-saxonne courante, permet de définir une pluralité de nanofils ou de nanosheets superposés.

Par souci de clarté les figures suivantes iB (i=3... 12) n'illustrent qu'un seul motif de « fin » 101M.

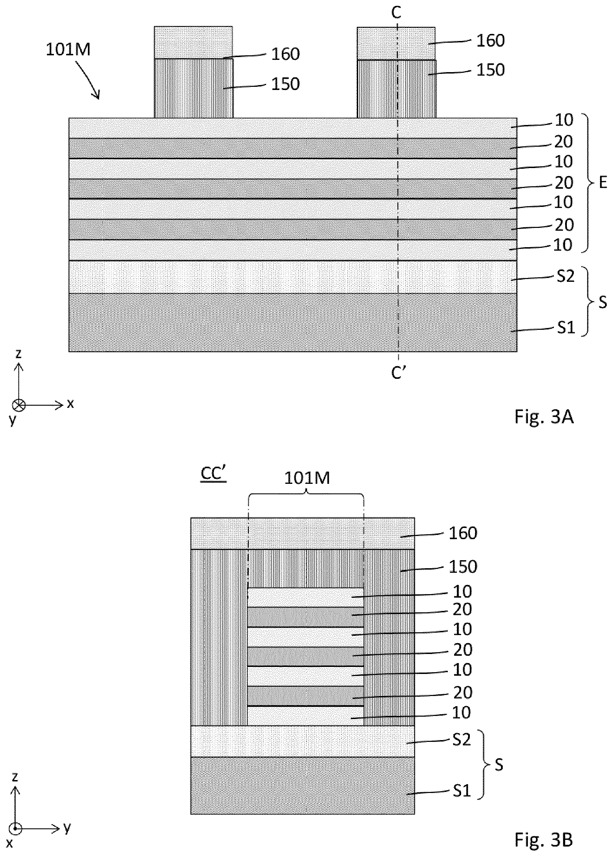

Comme illustré aux figures 3A, 3B, des grilles sacrificielles 150 sont ensuite formées sur les motifs de « fin » 101M. La formation de ces grilles sacrificielles 150 se fait typiquement par dépôt puis lithographie/gravure. La formation des grilles sacrificielles 150 est configurée de sorte que les grilles sacrificielles 150 soient à cheval sur les motifs de « fin » 101M, comme illustré en figure 3B. Les grilles sacrificielles 150 comprennent typiquement une partie supérieure située sur le motif de « fin » 101M, et des parties latérales situées sur les flancs latéraux du motif de « fin » 101M. Les grilles sacrificielles 150 prennent typiquement appui sur le substrat S. A ce stade, les grilles sacrificielles 150 sont typiquement surmontées par un masque de gravure 160, dit masque dur, mis en oeuvre dans la structuration des grilles sacrificielles 150. Les grilles sacrificielles 150 comprennent par exemple de façon connue une couche d'oxyde mince SiO2 (épaisseur entre 3 nm et 7 nm par exemple) et une couche épaisse de silicium polycristallin. La couche d'oxyde mince SiO2 peut former une couche d'arrêt lors de la gravure du silicium polycristallin des grilles sacrificielles 150. Le masque dur 160 peut être à base d'oxyde de silicium SiO2, de nitrure de silicium SiN, ou d'une bicouche SiO2/SiN.

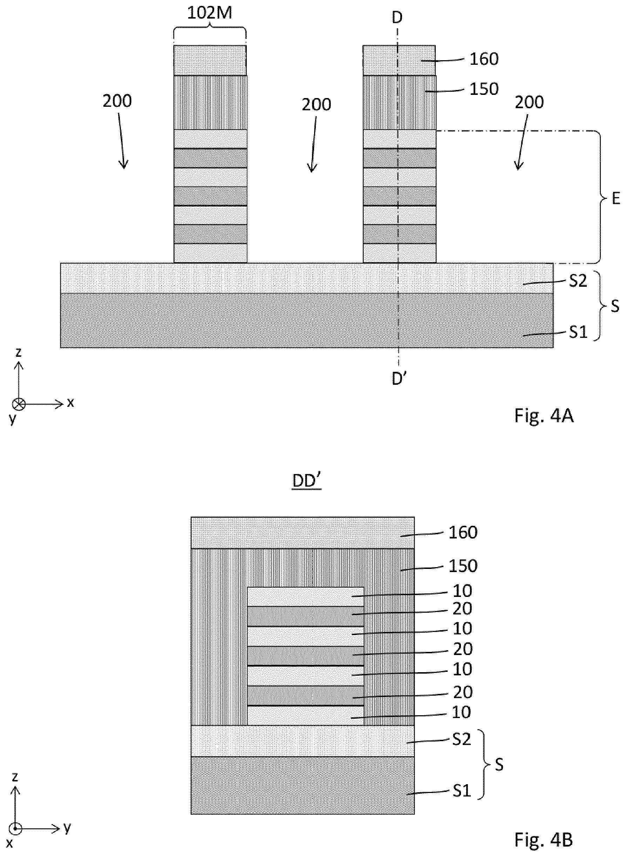

Comme illustré aux figures 4A, 4B, après formation des grilles sacrificielles 150 par lithographie/gravure, la gravure anisotrope selon z est prolongée afin de définir des deuxièmes motifs 102M, et des deuxièmes ouvertures 200. La gravure est configurée pour graver l'empilement E sur toute sa hauteur, en s'arrêtant sur le substrat S. Elle peut être effectuée par plasma en utilisant une chimie de gravure HBr/O2.

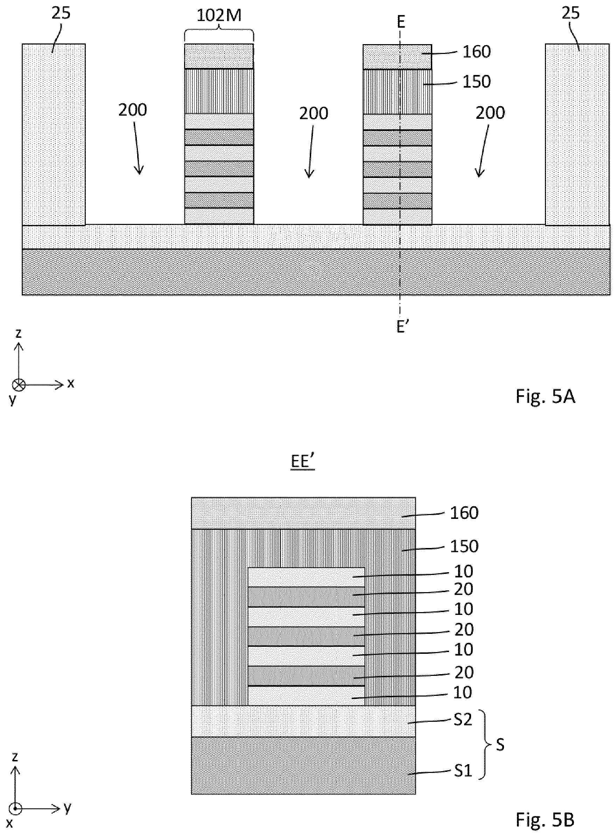

Comme illustré aux figures 5A, 5B, une couche diélectrique 25, par exemple à base de SiO2, est déposée sur et entre les deuxièmes motifs 102M. Cette couche diélectrique 25 est ensuite planarisée, typiquement par polissage mécano-chimique CMP avec arrêt sur les masques durs 160, puis ouverte par gravure de façon à reformer et/ou redéfinir les deuxièmes ouvertures 200. Les deuxièmes ouvertures 200 sont destinées à recevoir les contacts de source et de drain.

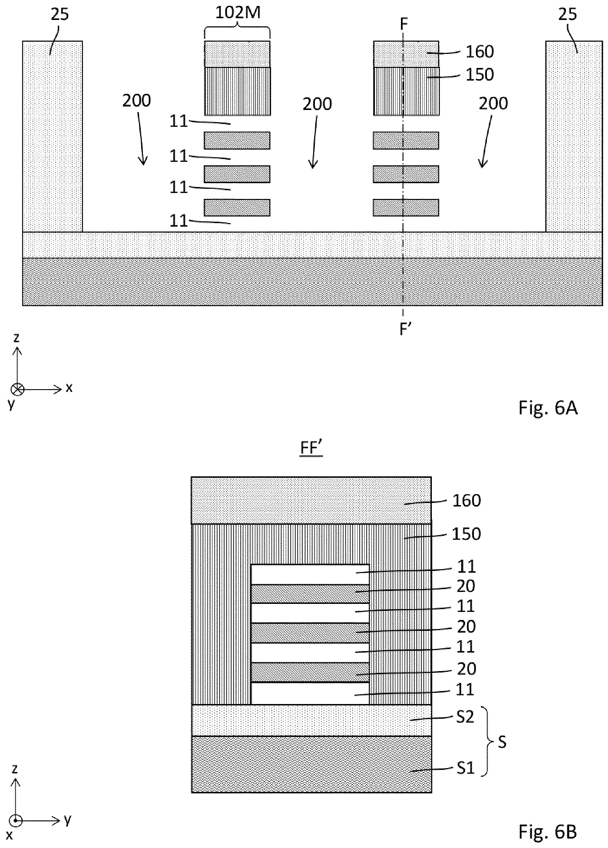

Comme illustré aux figures 6A, 6B, après formation des deuxièmes ouvertures 200, les premières couches 10 sont totalement gravées sélectivement aux deuxièmes couches 20, au substrat S et aux grilles sacrificielles 150. La gravure du premier matériau des premières couches 10 présente typiquement une sélectivité S_{10:20} par rapport au deuxième matériau des deuxièmes couches 20, d'au moins 5:1, de préférence au moins 10:1. Cette première gravure vise à former des premiers espaces 11 entre les deuxièmes couches 20 des deuxièmes motifs 102M. Cette gravure totale peut être arrêtée au temps, possiblement après un temps de sur-gravure visant à garantir le retrait total du premier matériau des premières couches 10. Cette gravure totale présente un caractère isotrope et peut être effectuée par voie humide ou par voie sèche, à partir des deuxièmes ouvertures 200.

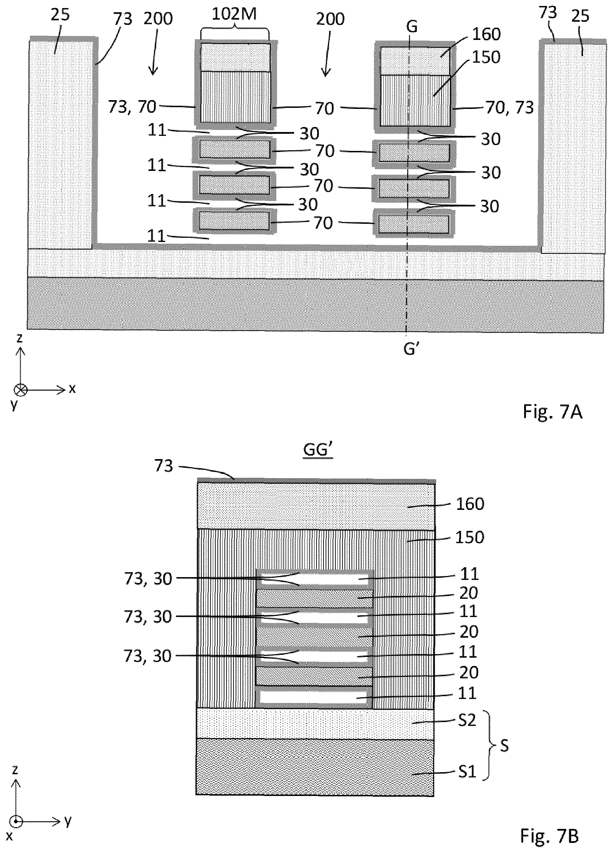

Comme illustré aux figures 7A, 7B, une couche continue 73 est ensuite déposée dans les deuxièmes ouvertures 200, autour des deuxièmes couches 20 des deuxièmes motifs 102M et autour des grilles sacrificielles 150, dans les premiers espaces 11. La couche continue 73 présente typiquement une permittivité comprise entre 4 et 25. Cette couche continue 73 peut ainsi être à base d'un matériau diélectrique à forte permittivité, par exemple à base de HfO2. La couche continue 73 est destinée à former à la fois la couche diélectrique de grille 30 entre les canaux des transistors GAA et leurs grilles enrobantes, et les espaceurs 70 sur les flancs des deuxièmes couches 20 et des grilles sacrificielles 150. Les portions horizontales de la couche continue 73 forment typiquement la couche diélectrique de grille 30. Les portions verticales de la couche continue 73 forment typiquement les espaceurs 70. La couche continue 73 peut être formée par dépôt chimique en phase vapeur CVD (acronyme de « Chemical Vapor Déposition »), par dépôt chimique en phase vapeur à précurseurs organométalliques MOCVD (acronyme de « Metal Organic Chemical Vapor Déposition ») ou par dépôt en couche atomique ALD (acronyme de « Atomic Layer Déposition »). La couche continue 73 présente typiquement une épaisseur comprise entre 1 nm et 5 nm. Elle peut être déposée de façon conforme. Elle présente alors une épaisseur sensiblement constante. Alternativement, le dépôt peut être configuré de façon à ce que les portions verticales de la couche continue 73 présentent une épaisseur supérieure aux portions horizontales de la couche continue 73.

Selon une possibilité, plusieurs couches continues 73 sont déposées les unes sur les autres. Cela permet d'ajuster les épaisseurs de la couche diélectrique de grille 30 et des espaceurs 70. Cela permet d'ajuster les propriétés diélectriques de la couche diélectrique de grille 30 et des espaceurs 70.

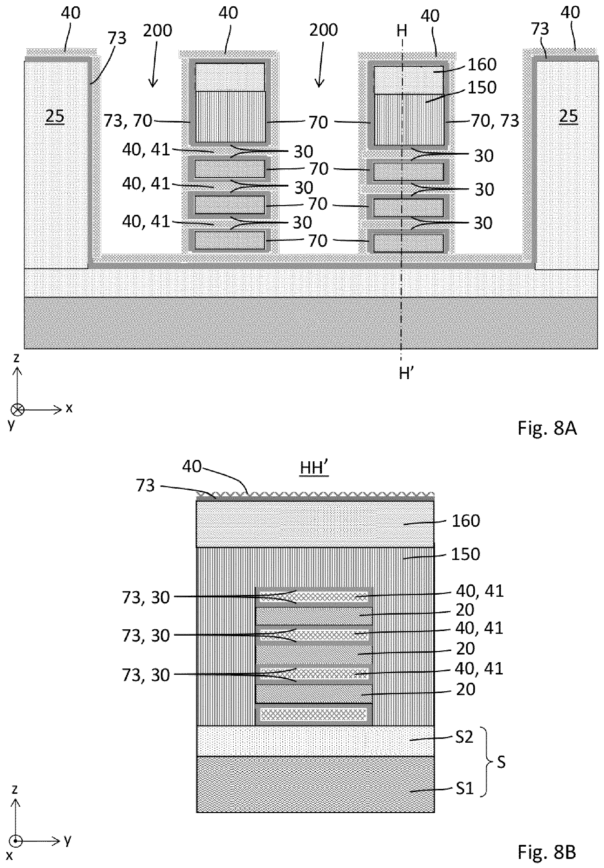

Comme illustré aux figures 8A, 8B, une couche 40 à base d'un matériau semiconducteur est ensuite déposée sur la couche continue 73 dans les premiers espaces 11. Le dépôt du matériau semiconducteur est ici configuré pour que la couche 40 remplisse totalement les premiers espaces 11. Les portions de la couche 40 situées dans les premiers espaces 11 présentent ainsi une épaisseur parfaitement contrôlée, proche de l'épaisseur des premières couches initiales. Cette couche 40 est destinée à former les canaux 41 des transistors GAA à l'aplomb des grilles sacrificielles 150 et des deuxièmes couches 20. Cette couche 40 est également destinée à former les sources 42 et les drains 43 des transistors GAA à l'aplomb des espaceurs 70.

La couche 40 est également typiquement déposée en dehors des premiers espaces 11, sur (une partie ou la totalité) des flancs des espaceurs 70. Cela permet d'améliorer la reprise de contact avec les sources 42 et les drains 43 des transistors GAA. La couche 40 présente ainsi des portions horizontales dans les premiers espaces 11, notamment entre les deuxièmes couches, et des portions verticales sur les flancs des espaceurs 70, sans discontinuité. Selon une possibilité, l'épaisseur des portions verticales de la couche 40 est plus importante que l'épaisseur des portions horizontales de la couche 40. Cela permet de réduire la résistance de contact pour les sources 42 et les drains 43 des transistors GAA.

Le matériau semiconducteur de la couche 40 est avantageusement un matériau bidimensionnel pris parmi les dichalcogénures de métaux de transition MX2 avec M le molybdène (Mo) ou le tungstène (W), et X le soufre (S), le sélénium (Se) ou le tellure (Te). Un tel matériau 2D peut être avantageusement déposé sous forme de couche mince comprenant 1 à 10 couches atomiques, de préférence 1 à 5 couches atomiques. Le dépôt de ce matériau 2D peut se faire par CVD, MOCVD ou ALD. Selon une autre possibilité, le matériau semiconducteur de la couche 40 est un oxyde semiconducteur tel que l'ITO (acronyme de « Indium Tin Oxide »), l'IGZO (acronyme de « Indium Gallium Zinc Oxide »), l'IWO (signifiant « tungsten doped indium oxide »), l'oxyde d'indium ln2O3. Selon une autre possibilité, le matériau semiconducteur de la couche 40 est un graphène, un nitrure de bore hexagonal « h-BN », un phosphorène (également connu sous le nom de « Black Phosphorous » BP), sous forme de monocouche ou de couche mince comprenant 1 à 10 couches atomiques, de préférence 1 à 5 couches atomiques.

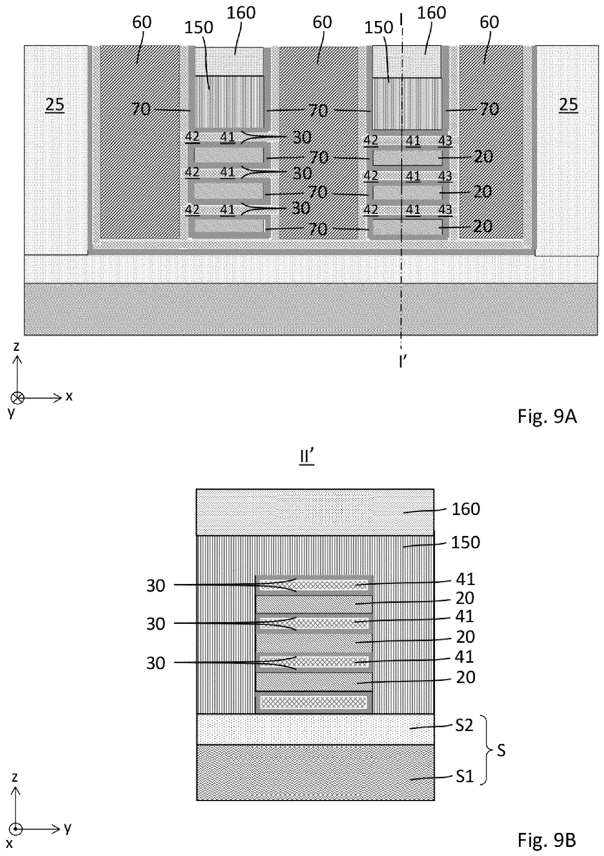

Comme illustré aux figures 9A, 9B, les deuxièmes ouvertures peuvent ensuite être remplies par une ou plusieurs couches métalliques 60, par exemple à base de Ti, TiN, W, afin de former les contacts de source et drain. Un polissage mécano-chimique CMP est typiquement effectué afin de retirer l'excès de métal déposé sur les motifs 102M. Les masques durs 160 sont ainsi exposés.

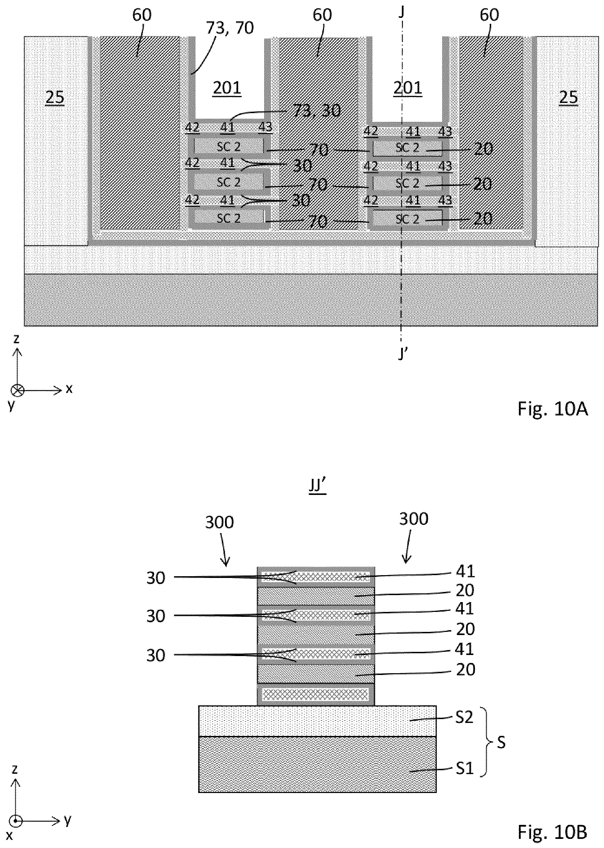

Comme illustré aux figures 10A, 10B, les masques durs 160 sont d'abord retirés, puis les grilles sacrificielles 150 sont également retirées. Un ou des bouchons d'oxyde peuvent être réalisés sur les contacts de source et drain avant ces retraits, pour protéger les couches métalliques 60 lors du retrait des masques durs 160 et des grilles sacrificielles 150. Ce retrait peut être effectué par gravure humide avec arrêt sur la couche continue 73. Cette gravure humide présente typiquement une sélectivité élevée vis-à-vis de la couche continue 73. Cette gravure humide peut être à base d'une solution de sels d'ammoniaque TMAH (Hydroxyde de Tétraméthylammonium) ou TEAH (Hydroxyde de Tétraéthylammonium). Le retrait des grilles sacrificielles 150 est typiquement effectué en deux étapes, avec une première gravure du silicium polycristallin et arrêt sur la couche d'oxyde mince SiO2, puis une deuxième gravure de cette couche d'oxyde mince SiO2. Le retrait des grilles sacrificielles 150 permet de former un espace principal 201 et des troisièmes ouvertures 300 débouchant sur les deuxièmes couches 20 (figure 10B).

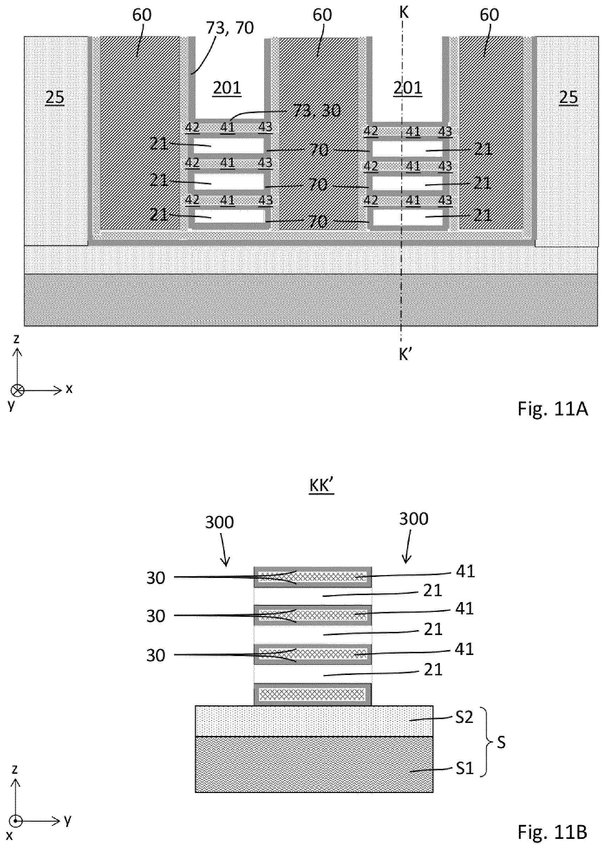

Comme illustré aux figures 11A, 11B, les deuxièmes couches 20 sont ensuite totalement retirées par gravure sélective vis-à-vis de la couche continue 73, à partir des troisièmes ouvertures 300. Cette gravure vise à former des deuxièmes espaces 21 à la place des deuxièmes couches 20. Cette gravure présente un caractère isotrope et peut être effectuée par voie humide ou par voie sèche, à partir des troisièmes ouvertures 300.

Comme illustré aux figures 12A, 12B, les espaces principaux 201 et les deuxièmes espaces 21 sont ensuite remplis par une ou plusieurs couches métalliques 50, par exemple à base de TiN, W, afin de former les grilles enrobantes des transistors GAA. Selon une possibilité, avant dépôt des couches métalliques 50, une couche diélectrique 51 à base d'un matériau à forte permittivité, par exemple à base de HfO2, est préalablement déposée dans les espaces principaux 201 et les deuxièmes espaces 21. Cela permet d'augmenter l'épaisseur de la couche diélectrique de grille entre les canaux 41 des transistors GAA et leurs grilles 50 enrobantes. Cela permet d'augmenter l'épaisseur des espaceurs entre les grilles 50 enrobantes et les sources et drains des transistors GAA. Un polissage mécano-chimique CMP est typiquement effectué afin de retirer l'excès de métal déposé sur les motifs 102M.

Un dispositif microélectronique comprenant deux transistors T1, T2 comprenant chacun quatre canaux 41a, 41b, 41c, 41d empilés selon z, à grille enrobante 50, est ainsi avantageusement obtenu. Les canaux 41a, 41b, 41c, 41d, les sources 42 et les drains 43 sont de préférence à base d'un matériau bidimensionnel. Des contacts de source et drain 60S, 60, 60D viennent connecter électriquement ces transistors GAAT1, T2.

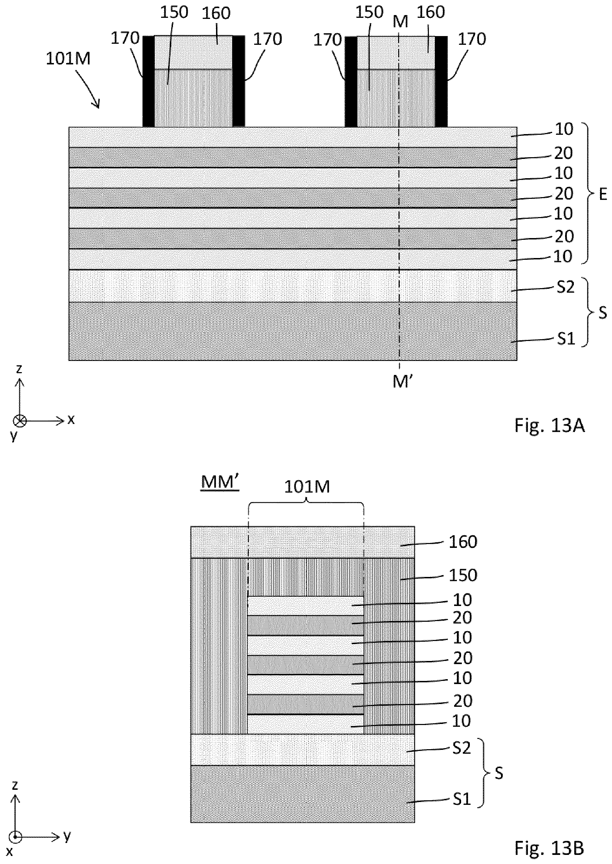

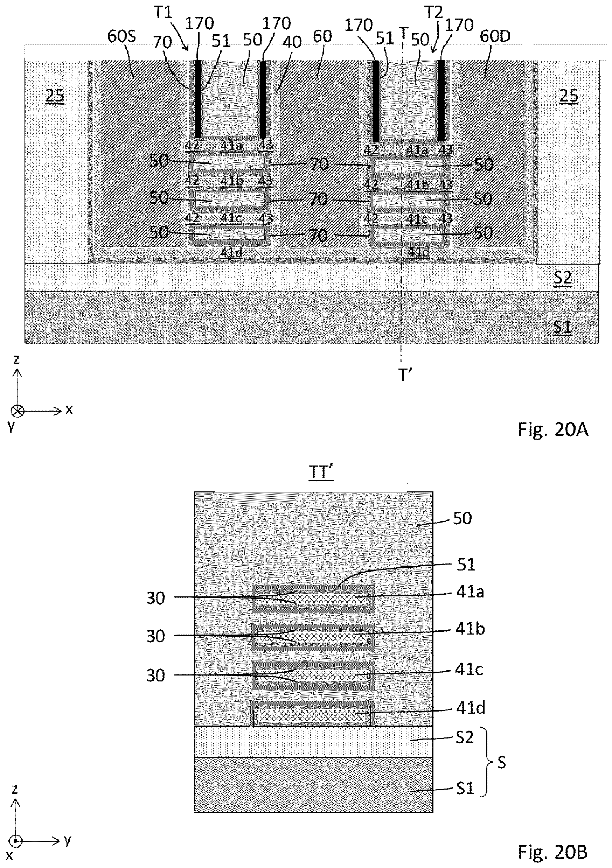

Les figures 13A, 13B à 20A, 20B illustrent schématiquement des étapes de fabrication d'un dispositif comprenant des transistors GAA selon un deuxième mode de réalisation. Les figures nA (n=13...20) correspondent à des premières coupes transverses illustrant chacune une étape différente du procédé de fabrication. Les figures nB (n=13...20) correspondent à des deuxièmes coupes transverses illustrant chacune la même étape que la figure nA correspondante.

Seules les caractéristiques différentes de ce deuxième mode de réalisation vis-à-vis du premier mode de réalisation sont décrites ci-après. Les autres caractéristiques sont réputées identiques à celles du premier mode de réalisation, en référence à ce qui précède.

Comme illustré aux figures 13A, 13B, après formation des premiers motifs 101M et des grilles sacrificielles 150 à cheval sur ces motifs 101M, des espaceurs 170 additionnels sont formés sur les flancs orientés selon yz des grilles sacrificielles 150. En général, en projection selon z, ces espaceurs forment une bague continue autour de chaque grille sacrificielle 150, avec un contour fermé. En coupe transverse cependant, selon le plan xz illustré à la figure 13A, l'espaceur 170 présente deux parties en vis-à-vis sur chacun des flancs de la grille sacrificielle 150. Ces deux parties sont généralement désignées comme étant les espaceurs 170, même si celles-ci peuvent être considérées comme appartenant à un seul et même espaceur. Les espaceurs 170 s'étendent typiquement jusqu'à une face supérieure des masques durs 160. Les espaceurs 170 sont typiquement à base de nitrure de silicium SiN ou d'un matériau diélectrique à faible constante diélectrique. Les espaceurs 170 présentent typiquement une épaisseur selon x comprise entre 2 nm et 7 nm. Ces espaceurs 170 peuvent être formés par un dépôt et une gravure anisotrope selon z.

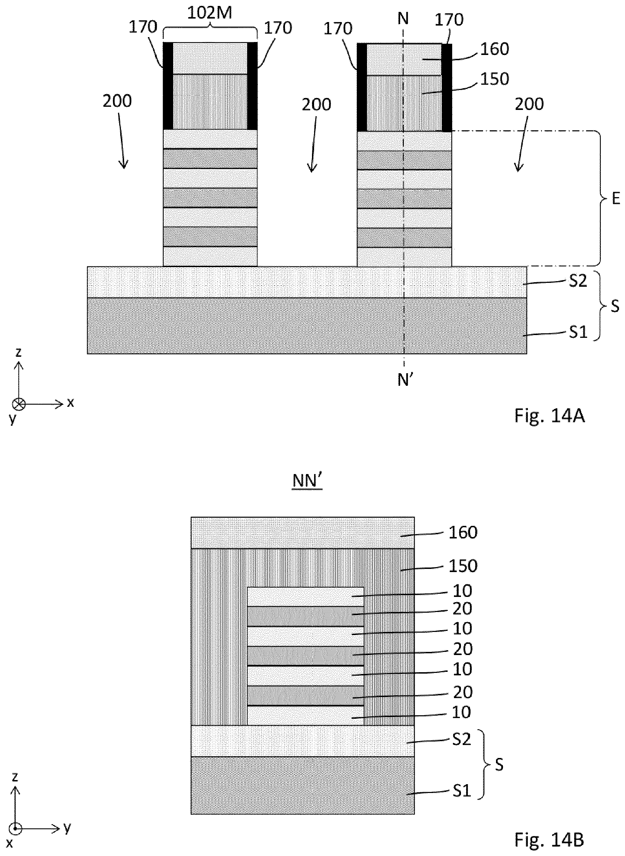

Comme illustré aux figures 14A, 14B, après formation des espaceurs 170 additionnels, la gravure anisotrope selon z est prolongée afin de définir les deuxièmes motifs 102M, et les deuxièmes ouvertures 200, comme précédemment.

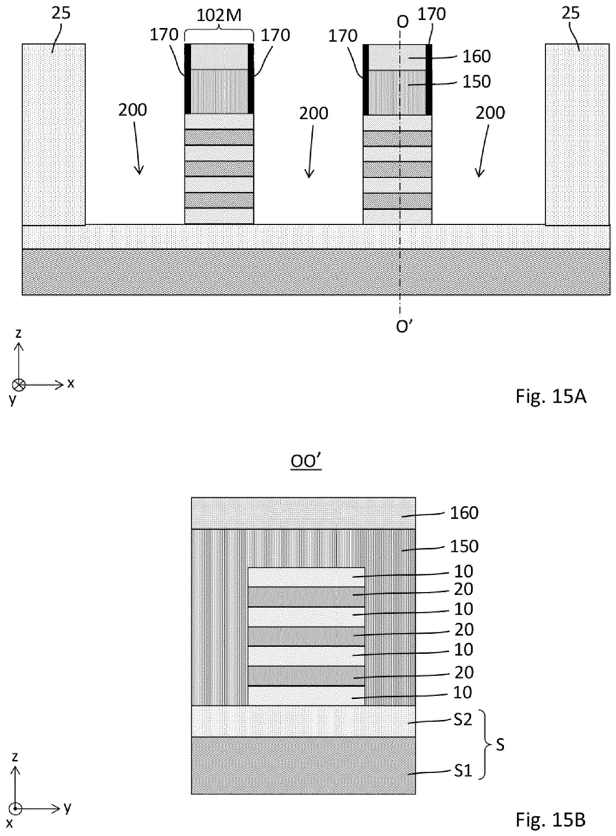

Comme illustré aux figures 15A, 15B, une couche diélectrique 25, par exemple à base de SiO₂, est déposée sur et entre les deuxièmes motifs 102M, puis planarisée et ouverte, comme précédemment.

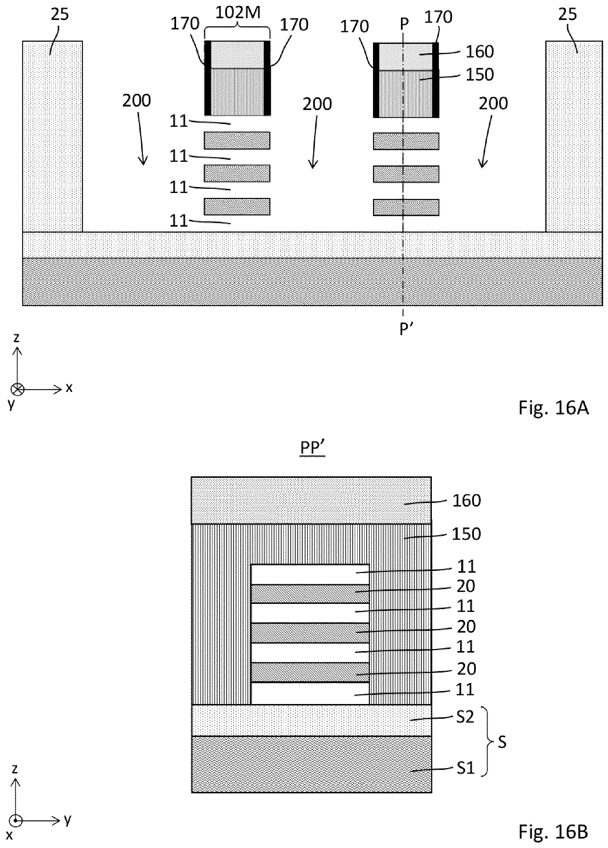

Comme illustré aux figures 16A, 16B, après formation des deuxièmes ouvertures 200, les premières couches 10 sont totalement gravées sélectivement aux deuxièmes couches 20 pour former les premiers espaces 11, comme précédemment.

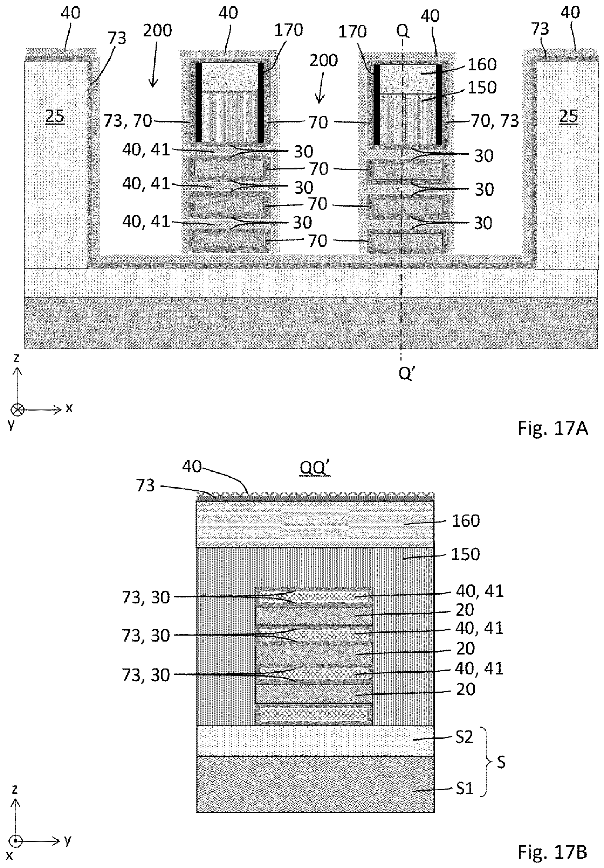

Comme illustré aux figures 17A, 17B, une couche continue 73 est ensuite déposée dans les deuxièmes ouvertures 200, autour des deuxièmes couches 20 des deuxièmes motifs 102M et sur les espaceurs 170 additionnels, dans les premiers espaces 11. Cette couche continue 73 est formée comme précédemment. Une couche 40 à base du matériau semiconducteur est ensuite déposée sur la couche continue 73 dans les premiers espaces 11 et sur les portions verticales de la couche continue 73. Cette couche 40 est formée comme précédemment.

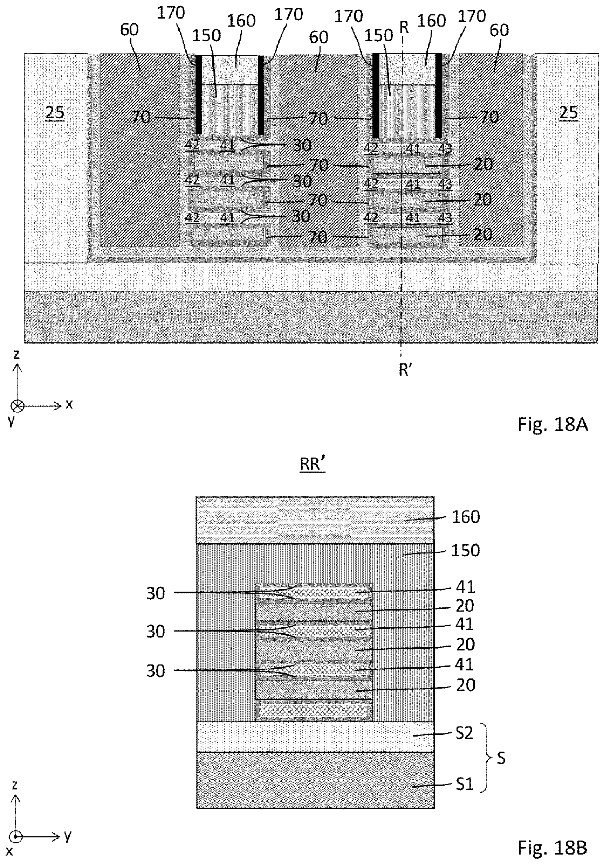

Comme illustré aux figures 18A, 18B, les deuxièmes ouvertures sont ensuite remplies par une ou plusieurs couches métalliques 60 pour former les contacts de source et drain, comme précédemment.

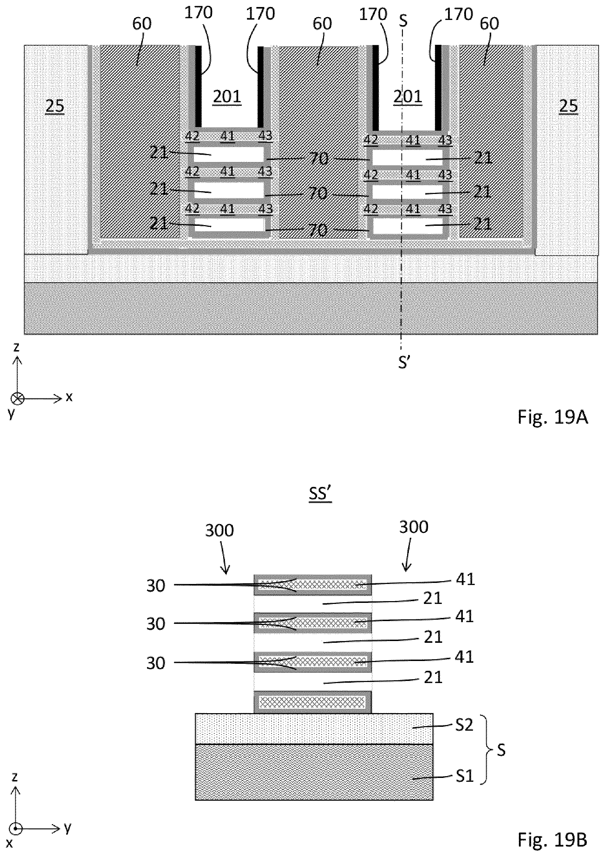

Comme illustré aux figures 19A, 19B, les masques durs 160 sont retirés, puis les grilles sacrificielles 150 sont également retirées. Ce retrait peut être effectué par gravure humide avec arrêt sur la couche continue 73 et sur les espaceurs 170. Cette gravure humide présente typiquement une sélectivité élevée vis-à-vis de la couche continue 73 et des espaceurs 170. Cette gravure humide peut être à base d'une solution de sels d'ammoniaque TMAH (Hydroxyde de Tétraméthylammonium) ou TEAH (Hydroxyde de Tétraéthylammonium). Les deuxièmes couches 20 sont ensuite totalement retirées par gravure sélective vis-à-vis de la couche continue 73, à partir des troisièmes ouvertures 300. Un espace principal 201 et des deuxièmes espaces 21 sont ainsi formés, comme précédemment.

Comme illustré aux figures 20A, 20B, les grilles 50 enrobantes sont ensuite formées dans les espaces principaux 201 et les deuxièmes espaces 21, comme précédemment. Une couche diélectrique 51 peut être préalablement déposée dans les espaces principaux 201 et les deuxièmes espaces 21, comme précédemment. Un dispositif microélectronique comprenant deux transistors T1, T2 comprenant chacun quatre canaux 41a, 41b, 41c, 41d empilés selon z, à grille enrobante 50, est ainsi avantageusement obtenu. Les canaux 41a, 41b, 41c sont totalement enrobés par la grille enrobante 50. Le canal 41d est partiellement enrobé par la grille enrobante 50. Les canaux 41a, 41b, 41c, 41d, les sources 42 et les drains 43 sont de préférence à base d'un matériau bidimensionnel. Des contacts de source et drain 60S, 60, 60D viennent connecter électriquement ces canaux 41a, 41b, 41c, 41d empilés selon z. Avantageusement, les espaceurs 170 additionnels de ce deuxième mode de réalisation permettent de réduire les capacités parasites du dispositif.

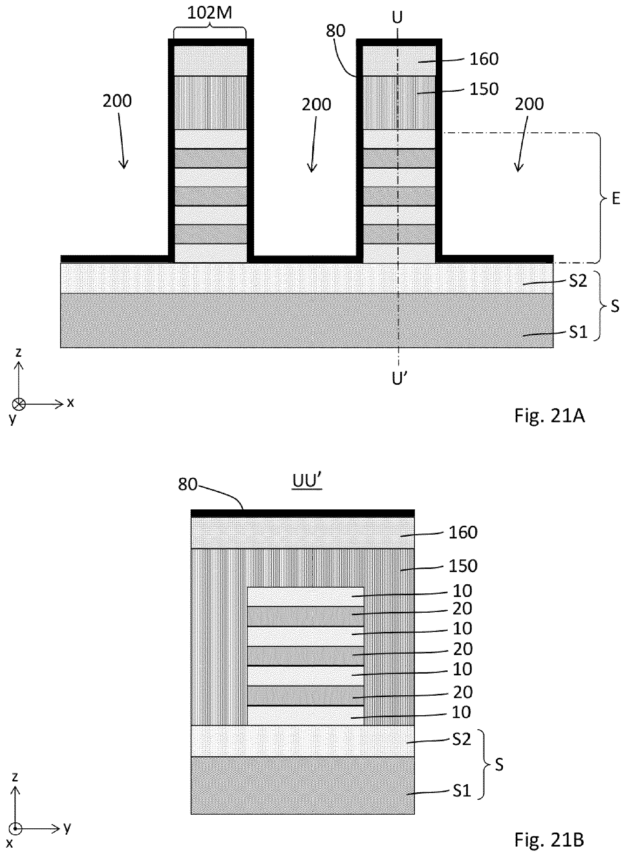

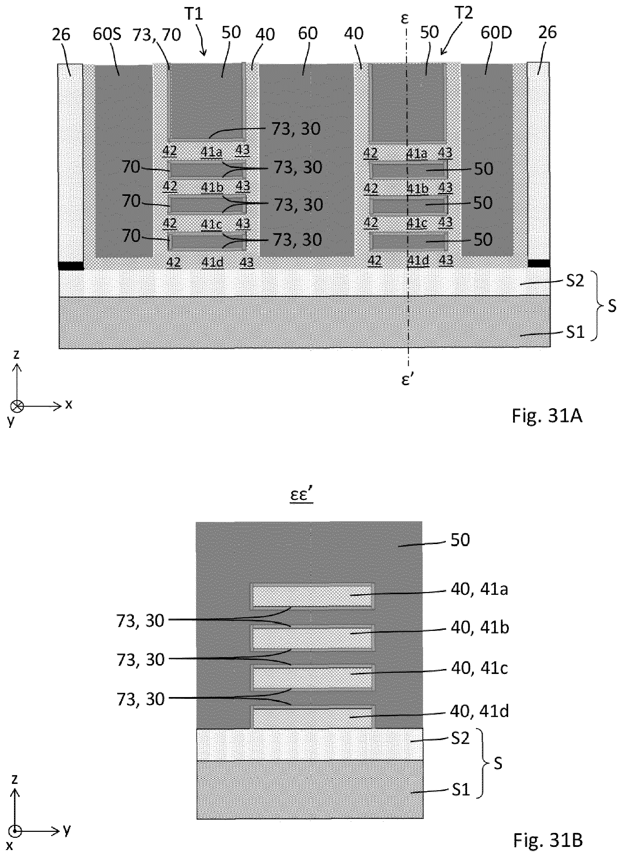

Les premier et deuxième modes de réalisation sont de type « gate last ». Les figures 21A, 21B à 31A, 31B illustrent schématiquement des étapes de fabrication d'un dispositif comprenant des transistors GAA selon un troisième mode de réalisation de type « gate first ». Les figures nA (n=21...31) correspondent à des premières coupes transverses illustrant chacune une étape différente du procédé de fabrication. Les figures nB (n=21...31) correspondent à des deuxièmes coupes transverses illustrant chacune la même étape que la figure nA correspondante.

Seules les caractéristiques différentes de ce troisième mode de réalisation vis-à-vis des premier et deuxième modes de réalisation sont décrites ci-après. Les autres caractéristiques sont réputées identiques à celles du premier et/ou du deuxième mode de réalisation, en référence à ce qui précède.

Comme illustré aux figures 21A, 21B, après formation des deuxièmes motifs 102M et des deuxièmes ouvertures 200 comme dans le premier mode de réalisation, une couche de maintien ou liner 80 est déposée sur lesdits motifs 102M et dans les deuxièmes ouvertures 200. Cette couche de maintien 80 est par exemple à base de SiN. Elle présente typiquement une épaisseur comprise entre 3 nm et 7 nm.

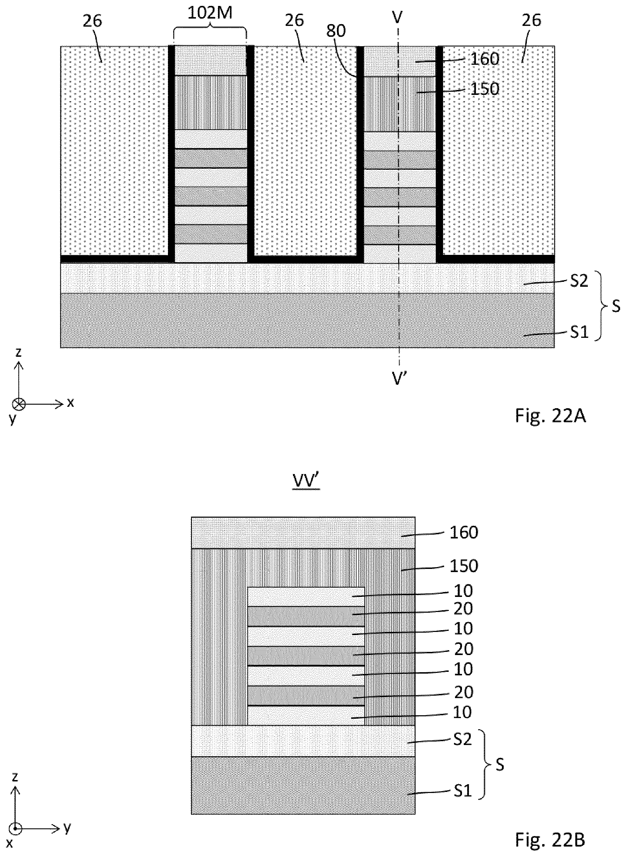

Comme illustré aux figures 22A, 22B, une couche diélectrique 26, par exemple à base de SiO2, est déposée sur la couche de maintien 80. Elle présente typiquement une grande épaisseur, par exemple de l'ordre de 600 nm. Cette couche diélectrique 26 est ensuite planarisée, typiquement par polissage mécano-chimique CMP avec arrêt sur les masques durs 160.

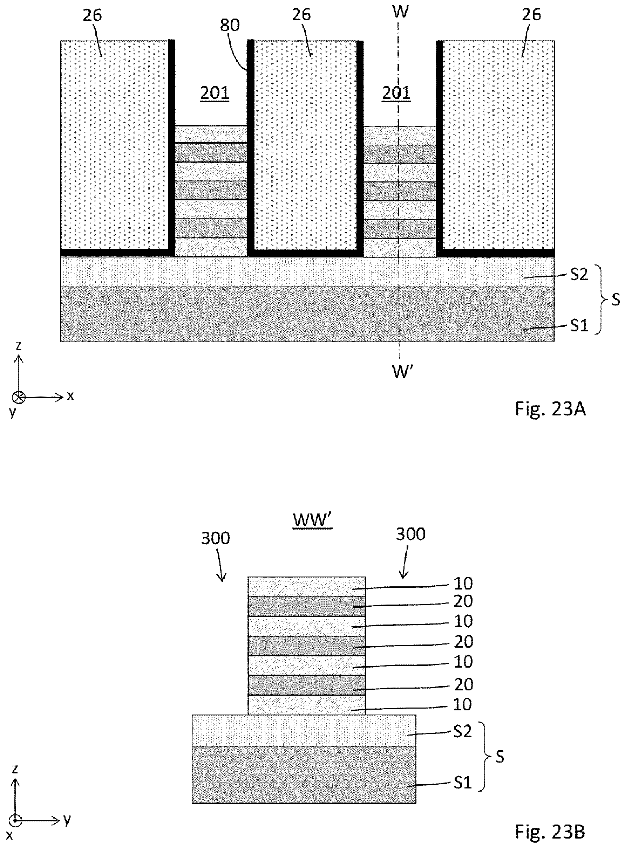

Comme illustré aux figures 23A, 23B, à ce stade les masques durs 160 sont retirés, puis les grilles sacrificielles 150 sont également retirées. Ce retrait peut être effectué par gravure humide avec arrêt sur la couche de maintien 80 et sur le premier matériau des premières couches 10. Cette gravure humide présente typiquement une sélectivité élevée vis-à-vis de la couche de maintien 80 et du premier matériau. Cette gravure humide peut être à base d'une solution de sels d'ammoniaque TMAH (Hydroxyde de Tétraméthylammonium) ou TEAH (Hydroxyde de Tétraéthylammonium).. Ce retrait des grilles sacrificielles 150 permet de former un espace principal 201 et des troisièmes ouvertures 300 débouchant notamment sur les deuxièmes couches 20 (figure 23B).

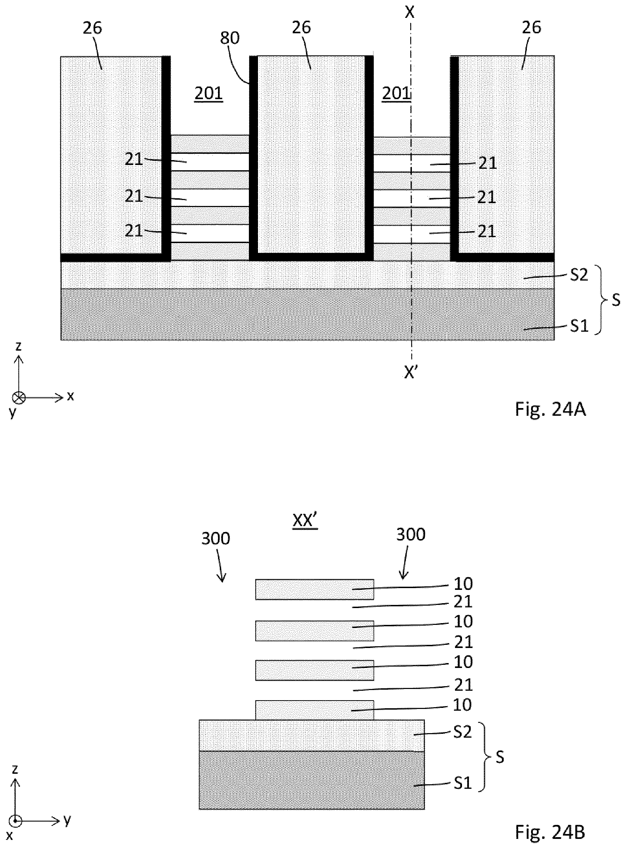

Comme illustré aux figures 24A, 24B, les deuxièmes couches 20 sont ensuite totalement retirées par gravure sélective vis-à-vis du premier matériau des premières couches 10, à partir des troisièmes ouvertures 300. Un espace principal 201 et des deuxièmes espaces 21 sont ainsi formés, comme précédemment.

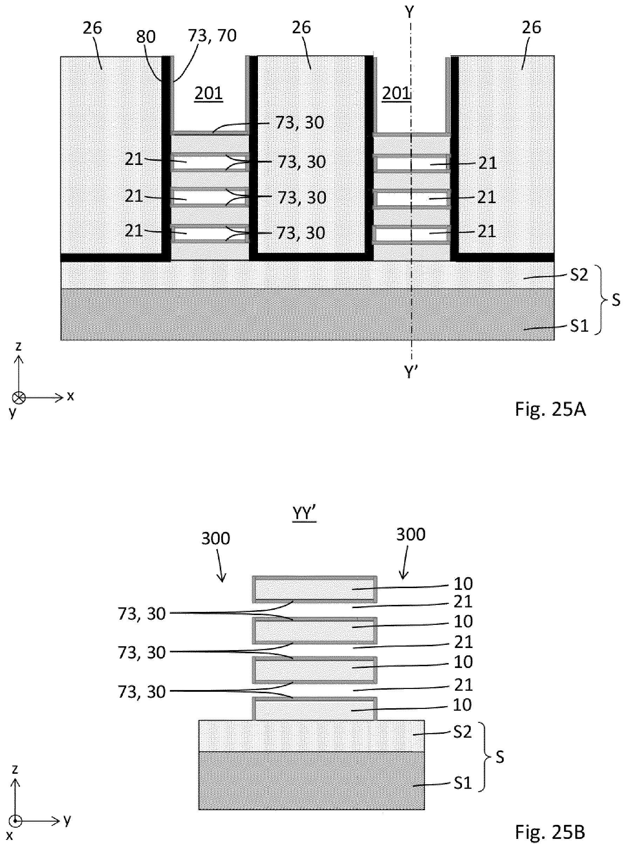

Comme illustré aux figures 25A, 25B, une couche continue 73 est ensuite déposée dans l'espace principal 201 et dans les deuxièmes espaces 21, à partir des troisièmes ouvertures 300. Cette couche continue 73 est formée comme précédemment. Elle est destinée à former à la fois la couche diélectrique de grille 30 entre les canaux des transistors GAA et leurs grilles enrobantes, et les espaceurs 70. Les portions horizontales de la couche continue 73 forment typiquement la couche diélectrique de grille 30. Les portions verticales de la couche continue 73 forment typiquement les espaceurs 70. Les espaceurs 70 prennent ici appui sur la couche de maintien 80.

Selon une possibilité, plusieurs couches continues 73, par exemple à base de SiO2 et/ou de HfO2 et/ou d'Al2O3, sont déposées les unes sur les autres. Cela permet d'ajuster les épaisseurs de la couche diélectrique de grille 30 et des espaceurs 70. Cela permet d'ajuster les propriétés diélectriques de la couche diélectrique de grille 30 et des espaceurs 70.

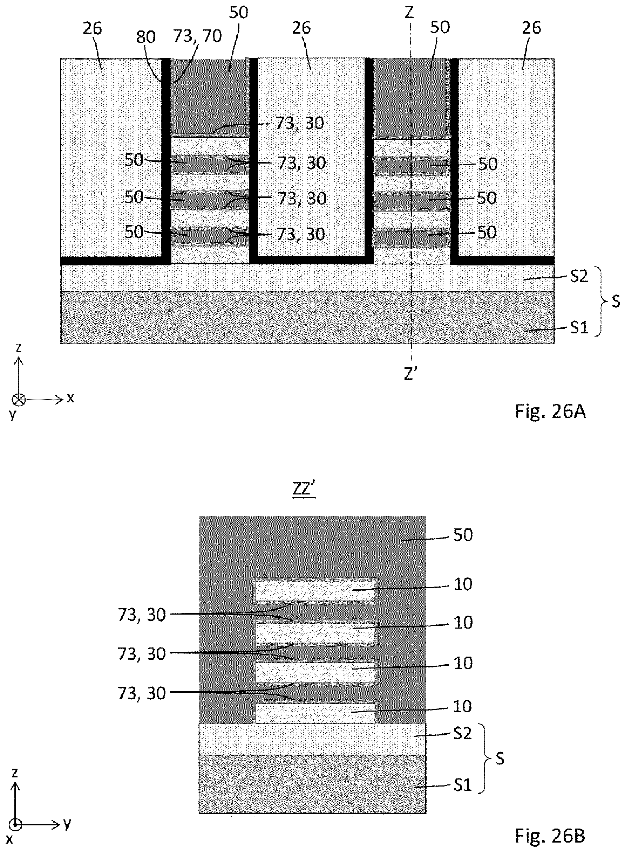

Comme illustré aux figures 26A, 26B, les espaces principaux 201 et les deuxièmes espaces 21 sont ensuite remplis par une ou plusieurs couches métalliques 50, par exemple à base de TiN, W, afin de former les grilles enrobantes des transistors GAA.

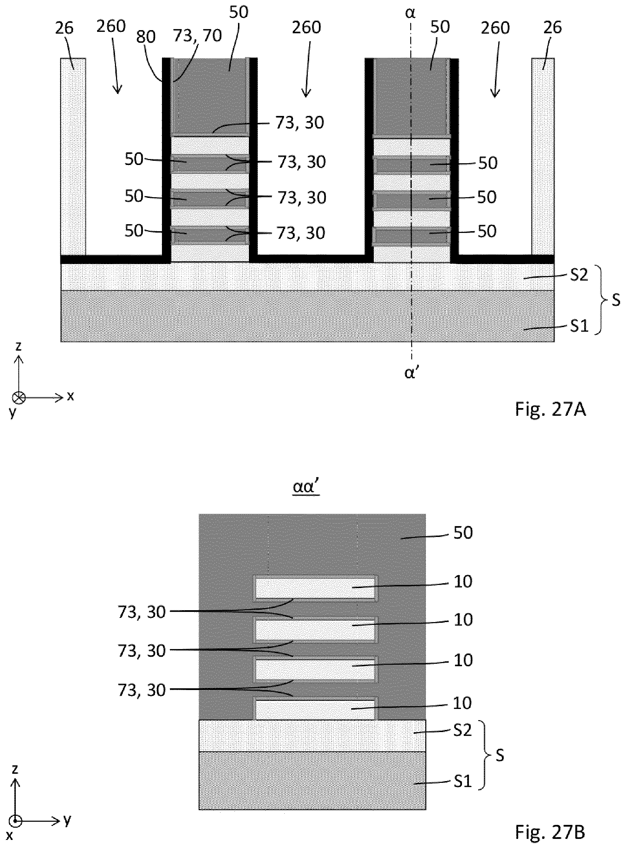

Comme illustré aux figures 27A, 27B, la couche 26 est ouverte par gravure de façon à former des ouvertures 260. Cette gravure s'arrête typiquement sur le liner 80. Un ou des bouchons à base de nitrure peuvent être réalisés sur les grilles 50 avant gravure de la couche 26, pour protéger les couches métalliques 50 lors de la gravure de cette couche 26.

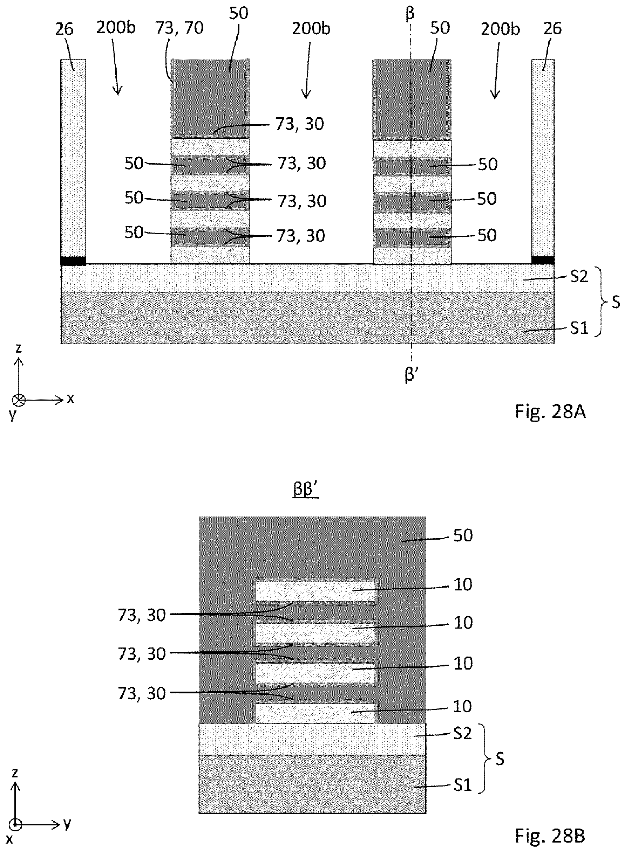

Comme illustré aux figures 28A, 28B, le liner 80 exposé dans les ouvertures 260 est retiré, sélectivement à la couche continue 73 et au premier matériau des premières couches 10. Ce retrait peut se faire par gravure humide ou par gravure sèche isotrope. Cette gravure humide peut être à base d'une solution d'acide phosphorique H3P04 concentré à 50%, effectuée à 100°C durant quelques dizaines de minutes, par exemple 30 min. Les deuxièmes ouvertures 200b sont ainsi reformées. Les deuxièmes ouvertures 200b sont destinées à accueillir les contacts de source et drain. Elles débouchent sur les premières couches 10.

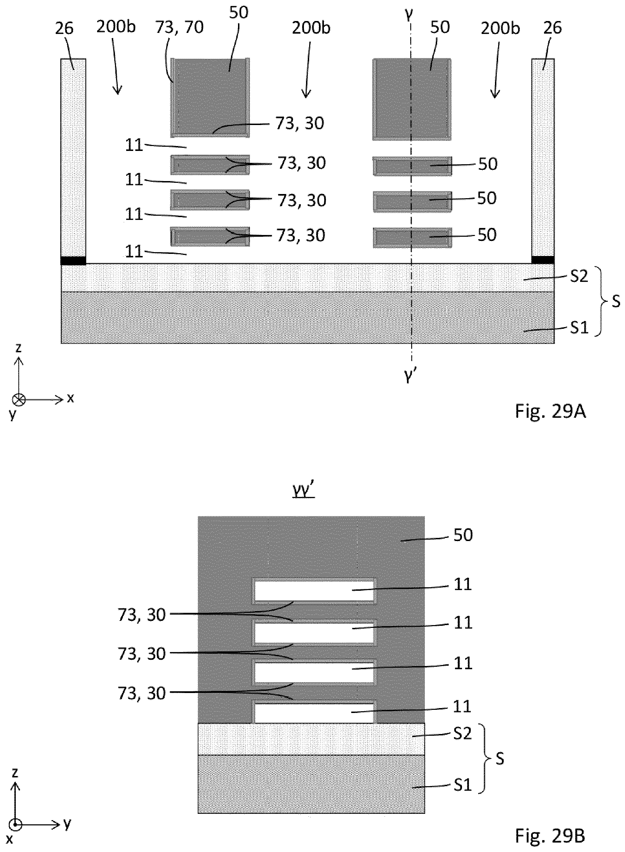

Comme illustré aux figures 29A, 29B, les premières couches 10 sont ensuite totalement retirées par gravure sélective vis-à-vis de la couche continue 73, à partir des deuxièmes ouvertures 200b. Cette gravure vise à former des premiers espaces 11 à la place des premières couches 10. Cette gravure présente un caractère isotrope et peut être effectuée par voie humide ou par voie sèche, à partir des deuxièmes ouvertures 200b.

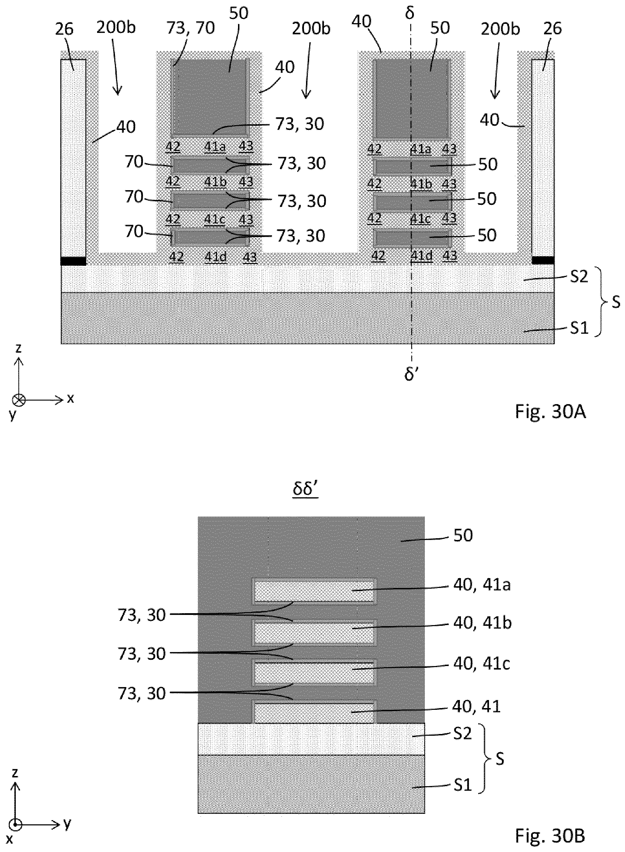

Comme illustré aux figures 30A, 30B, la couche 40 à base du matériau semiconducteur est ensuite déposée sur la couche continue 73 dans les premiers espaces 11. Le dépôt du matériau semiconducteur est ici configuré pour que la couche 40 remplisse totalement les premiers espaces 11. Les portions de la couche 40 situées dans les premiers espaces 11 présentent ainsi une épaisseur parfaitement contrôlée, environ égale à l'épaisseur des premières couches initiales. Cette couche 40 est destinée à former les canaux 41 des transistors GAA à l'aplomb des grilles sacrificielles 150 et des deuxièmes couches 20. Cette couche 40 est également destinée à former les sources 42 et les drains 43 des transistors GAA à l'aplomb des espaceurs 70 et de préférence sur les flancs verticaux des espaceurs 70.

La couche 40 est également typiquement déposée en dehors des premiers espaces 11, sur une partie ou la totalité des flancs des espaceurs 70. Cela permet d'améliorer la reprise de contact avec les sources 42 et les drains 43 des transistors GAA. Le matériau semiconducteur de la couche 40 est avantageusement un matériau 2D, comme précédemment.

Comme illustré aux figures 31A, 31B, les deuxièmes ouvertures 200b peuvent ensuite être remplies par une ou plusieurs couches métalliques 60, par exemple à base de Ti, TiN, W, afin de former les contacts de source et drain. Un polissage mécano-chimique CMP est typiquement effectué afin de retirer l'excès de métal déposé sur les motifs 102M. Les sommets des grilles 50 sont ainsi exposés.

Un dispositif microélectronique comprenant deux transistors T1, T2, comprenant chacun quatre canaux 41a, 41b, 41c, 41d empilés selon z, à grille 50 enrobante ou partiellement enrobante, est ainsi avantageusement obtenu. Les canaux 41a, 41b, 41c, 41d, les sources 42 et les drains 43 sont de préférence à base d'un matériau bidimensionnel. Des contacts de source et drain 60S, 60, 60D viennent connecter électriquement les canaux 41a, 41b, 41c, 41d de ces transistors GAA T1, T2.

Au vu de la description qui précède, il apparaît clairement que le procédé proposé offre une solution particulièrement efficace pour former des transistors GAA à base de matériau 2D. Cette solution est en outre avantageusement compatible avec les procédés standards de la microélectronique. L'invention n'est cependant pas limitée aux modes de réalisations précédemment décrits.

Selon une possibilité non illustrée, la couche 40 à base du matériau semiconducteur ne remplit pas totalement les premiers espaces 11. Dans ce cas, les portions de la couche 40 situées dans les premiers espaces 11 peuvent être significativement plus minces que les premières couches initiales. Ces portions horizontales peuvent présenter une épaisseur correspondant à quelques couches atomiques seulement, par exemple entre 1 et 5 couches atomiques de matériau semiconducteur. Cela permet de réduire les dimensions des canaux 41 des transistors GAA. Les performances des transistors GAA peuvent être améliorées. Un bouchon diélectrique est typiquement formé entre les portions horizontales de la couche 40, afin de remplir les premiers espaces 11. Cela permet de travailler avec une seule monocouche de matériau 2D ce qui permet d'obtenir un excellent contrôle électrostatique du dispositif. La longueur de grille peut ainsi être avantageusement réduite. Cela permet également d'améliorer la résistance mécanique du dispositif et/ou d'éviter des déformations des canaux des transistors GAA, par exemple par échauffement lors du fonctionnement. Ce bouchon diélectrique peut être formé par dépôt CVD et gravure, de façon classique.

D'autres modes de réalisation sont envisageables. Les espaceurs additionnels du deuxième mode de réalisation peuvent par exemple être ajoutés dans le cadre du troisième mode de réalisation, pour former un autre mode de réalisation. Les caractéristiques compatibles des différents modes de réalisation peuvent être combinées entre elles pour former un mode de réalisation qui n'est pas nécessairement illustré ou décrit.

## Revendications

1. Dispositif microélectronique comprenant au moins un transistor (T1, T2) comprenant :
• Au moins deux canaux (41a, 41b, 41c) empilés selon une direction principale (z), chaque canal étant à base d'un matériau semiconducteur,
• une grille (50) dite enrobante, entourant totalement au moins un des canaux (41a, 41b, 41c), et de préférence plusieurs canaux (41a, 41b, 41c),
• une source (42) et un drain (43) de part et d'autre de chaque canal (41a, 41b, 41c), et des contacts (60S, 60, 60D) de source et de drain connectés respectivement à la source (42) et au drain (43),
• une couche diélectrique de grille (30) séparant chaque canal (41a, 41b, 41c) et la grille (50) enrobante,
• des espaceurs (70) de part et d'autre de la grille (50), configurés pour isoler électriquement la grille (50) vis-à-vis des contacts (60S, 60, 60D) de source et de drain,
le dispositif étant **caractérisé en ce que** la couche diélectrique de grille (30) et les espaceurs (70) sont formés par une même couche continue (73) entourant la grille (50) enrobante, et **en ce que** chaque canal (41a, 41b, 41c), source (42) et drain (43) sont formés par une même couche (40) à base du matériau semiconducteur, ladite couche (40) entourant totalement la couche continue (73) et présentant des portions verticales sur les flancs des espaceurs (70) et des portions horizontales sur chaque couche diélectrique de grille (30).

2. Dispositif selon la revendication précédente dans lequel ladite couche continue (73) présente des parties dites horizontales, s'étendant dans un plan perpendiculaire à la direction principale (z) et des parties dites verticales, s'étendant dans des plans parallèles à la direction principale (z), et dans lequel la couche diélectrique de grille (30) correspond aux parties horizontales de la couche continue (73), et les espaceurs (70) correspondent aux parties verticales de la couche continue (73).

3. Dispositif selon l'une quelconque des revendications précédentes dans lequel la source (42) et le drain (43) sont communs à tous les canaux (41a, 41b, 41c) de l'au moins un transistor (T1, T2).

4. Dispositif selon l'une quelconque des revendications précédentes dans lequel le matériau semiconducteur des canaux est pris parmi :
• les dichalcogénures de métaux de transition MX2 avec M pris parmi le molybdène (Mo) ou le tungstène (W), et X pris parmi le soufre (S), le sélénium (Se) ou le tellure (Te), ou
• un oxyde semiconducteur, par exemple IGZO (Oxyde de zinc-indium-gallium), ln2O3, IWO (Oxyde d'indium dopé au tungstène), ITO (Oxyde d'indium-étain), IAZO (Oxyde de zinc-indium-aluminium), InGaZnO, InGaO, InZnO ou un oxyde semiconducteur amorphe, ou
• le graphène, le nitrure de bore hexagonal ou le phosphorène.

5. Dispositif selon l'une quelconque des revendications précédentes dans lequel la couche continue (73) présente une épaisseur comprise entre 1 nm et 5 nm.

6. Procédé de fabrication d'un dispositif microélectronique selon l'une quelconque des revendications précédentes, ledit procédé comprenant les étapes suivantes :
• Fournir sur un substrat (S) un empilement (E) selon la direction principale (z) comprenant une première pluralité de premières couches (10) en un premier matériau alternées avec une deuxième pluralité de deuxièmes couches (20) en un deuxième matériau, les premier et deuxième matériaux étant différents dudit matériau semiconducteur,
• Former dans cet empilement (E) des premières ouvertures (100) définissant des premiers motifs (101M),
• Former des grilles sacrificielles (150) à cheval sur les premiers motifs (101M) et en partie dans les premières ouvertures (100),
• Former dans les premiers motifs (101M) des deuxièmes ouvertures (200) définissant des deuxièmes motifs (102M),
• Retirer totalement, à partir des deuxièmes ouvertures (200, 200b), le premier matériau des premières couches (10) de sorte à former des premiers espaces (11),
• Retirer les grilles sacrificielles (150) de sorte à former des troisièmes ouvertures (300),
• Retirer totalement, à partir des troisièmes ouvertures (300), le deuxième matériau des deuxièmes couches (11), de sorte à former des deuxièmes espaces (21),
• Déposer une couche continue (73), à base d'un matériau diélectrique, autour des deuxièmes couches (20) ou dans les deuxièmes espaces (21), de façon à former :
∘ Une couche diélectrique de grille (30) à partir des parties horizontales de la couche continue (73),
∘ Des espaceurs (70) à partir des parties verticales de la couche continue (73),
• Après formation de la couche continue (73), déposer une couche (40) à base d'un matériau semiconducteur dans les premiers espaces (11), de sorte à former :
∘ des canaux (41a, 41b, 41c) à base du matériau semiconducteur, et
∘ des sources (42) et drains (43) à base du matériau semiconducteur de part et d'autre des canaux (41),
• Après formation de la couche continue (73), remplir par un matériau, dit matériau de grille, les deuxièmes espaces (21), de façon à former des grilles (50) dites enrobantes entourant totalement au moins un des canaux (41a, 41b, 41c) de l'au moins un transistor (T1, T2).

7. Procédé selon la revendication précédente dans lequel le retrait des grilles sacrificielles (150) et le retrait du deuxième matériau des deuxièmes couches (20) sont effectués après dépôt de la couche (40) à base du matériau semiconducteur, et dans lequel le dépôt de la couche continue (73) se fait autour des deuxièmes couches (20).

8. Procédé selon la revendication précédente dans lequel le retrait du premier matériau des premières couches (10) est effectué sélectivement au deuxième matériau des deuxièmes couches (20).

9. Procédé de fabrication d'un dispositif microélectronique selon l'une quelconque des revendications 6 à 8, ledit procédé comprenant les étapes ci-dessous enchaînées dans l'ordre suivant :
• Fournir sur un substrat (S) l'empilement (E) selon la direction principale (z) comprenant la première pluralité de premières couches (10) en un premier matériau alternées avec la deuxième pluralité de deuxièmes couches (20) en un deuxième matériau, les premier et deuxième matériaux étant différents du matériau semiconducteur,
• Former dans cet empilement (E) les premières ouvertures (100) définissant les premiers motifs (101M),
• Former les grilles sacrificielles (150) à cheval sur les premiers motifs (101M) et en partie dans les premières ouvertures (100),
• Former dans les premiers motifs (101M) les deuxièmes ouvertures (200) définissant les deuxièmes motifs (102M),
• Retirer totalement, à partir des deuxièmes ouvertures (200), le premier matériau des premières couches (10) de sorte à former les premiers espaces (11),
• Déposer la couche continue (73), à base d'un matériau diélectrique, autour des deuxièmes couches (20), de façon à former :
∘ la couche diélectrique de grille (30) à partir des parties horizontales de la couche continue (73),
∘ les espaceurs (70) à partir des parties verticales de la couche continue (73),
• Déposer la couche (40) à base d'un matériau semiconducteur sur la couche continue (73), dans les premiers espaces (11), de sorte à former :
∘ les canaux (41a, 41b, 41c) à base du matériau semiconducteur, et
∘ les sources (42) et drains (43) à base du matériau semiconducteur de part et d'autre des canaux (41),
• Retirer les grilles sacrificielles (150) de sorte à former les troisièmes ouvertures (300),
• Retirer totalement, à partir des troisièmes ouvertures (300), le deuxième matériau des deuxièmes couches (11), de sorte à former les deuxièmes espaces (21),
• Remplir par le matériau de grille les deuxièmes espaces (21), de façon à former les grilles (50) enrobantes entourant totalement au moins un canal (41a, 41b, 41c) de l'au moins un transistor (T1, T2).

10. Procédé selon la revendication 6 dans lequel le retrait des grilles sacrificielles (150) et le retrait du deuxième matériau des deuxièmes couches (20) sont effectués avant dépôt de la couche (40) à base du matériau semiconducteur, et dans lequel le dépôt de l'au moins une couche continue (73) se fait dans les deuxièmes espaces (21).

11. Procédé selon la revendication précédente comprenant en outre, après formation des deuxièmes ouvertures (200), un dépôt d'au moins une couche de maintien (80) dans lesdites deuxièmes ouvertures (200), sur des flancs exposés des premières et deuxièmes couches (10, 20).

12. Procédé selon la revendication précédente comprenant en outre, après remplissage des deuxièmes espaces (21) par le matériau de grille, un retrait de l'au moins une couche de maintien (80) de façon à exposer les flancs des premières couches (10).

13. Procédé de fabrication d'un dispositif microélectronique selon la revendication précédente, ledit procédé comprenant les étapes ci-dessous enchaînées dans l'ordre suivant :
• Fournir sur un substrat (S) l'empilement (E) selon la direction principale (z) comprenant la première pluralité de premières couches (10) en un premier matériau alternées avec la deuxième pluralité de deuxièmes couches (20) en un deuxième matériau, les premier et deuxième matériaux étant différents du matériau semiconducteur,
• Former dans cet empilement (E) les premières ouvertures (100) définissant les premiers motifs (101M),
• Former les grilles sacrificielles (150) à cheval sur les premiers motifs (101M) et en partie dans les premières ouvertures (100),
• Former dans les premiers motifs (101M) les deuxièmes ouvertures (200, 200b) définissant les deuxièmes motifs (102M),
• Former la couche de maintien (80) dans lesdites deuxièmes ouvertures (200), sur des flancs exposés des premières et deuxièmes couches (10, 20),
• Retirer les grilles sacrificielles (150) de sorte à former les troisièmes ouvertures (300),
• Retirer totalement, à partir des troisièmes ouvertures (300), le deuxième matériau des deuxièmes couches (11), de sorte à former les deuxièmes espaces (21),
• Déposer la couche continue (73), à base d'un matériau diélectrique, dans les deuxièmes espaces (21), de façon à former :
∘ la couche diélectrique de grille (30) à partir des parties horizontales de la couche continue (73),
∘ les espaceurs (70) à partir des parties verticales de la couche continue (73),
• Remplir par le matériau de grille les deuxièmes espaces (21), de façon à former les grilles (50) enrobantes,
• Retirer la couche de maintien (80) de façon à exposer les flancs des premières couches (10),
• Retirer totalement, à partir des deuxièmes ouvertures (200b), le premier matériau des premières couches (10) de sorte à former les premiers espaces (11),
• Déposer la couche (40) à base d'un matériau semiconducteur sur la couche continue (73), dans les premiers espaces (11), de sorte à former :
∘ les canaux (41a, 41b, 41c) à base du matériau semiconducteur, et
∘ les sources (42) et drains (43) à base du matériau semiconducteur de part et d'autre des canaux (41).

14. Procédé selon l'une quelconque des revendications 6 à 13 dans lequel le matériau semiconducteur est un matériau bidimensionnel (2D) choisi parmi les dichalcogénures de métaux de transition MX2 avec M pris parmi le molybdène (Mo) ou le tungstène (W), et X pris parmi le soufre (S), le sélénium (Se) ou le tellure (Te).

15. Procédé selon l'une quelconque des revendications 6 à 14 dans lequel les espaceurs (70) sont uniquement formés à partir des parties verticales de la couche continue (73), sans autre contribution telle que des bouchons diélectriques préalablement réalisés sur des flancs des deuxièmes couches (20).
